# EUROPEAN PATENT APPLICATION

(11) **EP 4 597 766 A1**
(43) Date of publication of application: **06.08.2025**
(21) Application number: 23871592.4
(22) Date of filing: 23.08.2023
(51) Int. Cl.: H01S 5/20, H01L 33/32, H01S 5/343

(54) **NITRIDE-BASED SEMICONDUCTOR LIGHT-EMITTING DEVICE**

(30) Priority: 27.09.2022 JP 2022153433
(71) Applicant: Nuvoton Technology Corporation Japan, Nagaokakyo City, Kyoto 617-8520 (JP)
(72) Inventor: YOSHIDA, Shinji, Nagaokakyo City, Kyoto 617-8520 (JP); TAKAYAMA, Toru, Nagaokakyo City, Kyoto 617-8520 (JP); OKAGUCHI, Takahiro, Nagaokakyo City, Kyoto 617-8520 (JP); INOUE, Noboru, Nagaokakyo City, Kyoto 617-8520 (JP)
(74) Representative: Novagraaf International SA
(86) International application number: PCT/JP2023/030351
(87) International publication number: WO 2024/070351

(57) **Abstract**

A nitride semiconductor light-emitting element (100) emits light and includes an N-type cladding layer (104), an N-side optical guide layer (106), an active layer (107), an electron blocking layer (109), a P-type interlayer (110), a P-side optical guide layer (111), and a P-type cladding layer (112). Average band gap energy of the electron blocking layer (109) is higher than average band gap energy of the P-type cladding layer (112). Average band gap energy of the P-type interlayer (110) is higher than average band gap energy of the P-side optical guide layer (111), and is smaller than the average band gap energy of the electron blocking layer (109). An average impurity concentration of the P-type interlayer (110) is lower than an average impurity concentration of the electron blocking layer (109), and is higher than an average impurity concentration of the P-side optical guide layer (111). A peak wavelength of the light is less than 400 nm.

## Description

### [Technical Field]

The present disclosure relates to nitride semiconductor light-emitting elements.

### [Background Art]

Nitride semiconductor light-emitting elements such as nitride semiconductor laser elements that emit light in an ultraviolet range have been conventionally known (e.g., Patent Literature (PTL) 1). Since the light in the ultraviolet range has higher energy than visible light, optical absorption increases especially in, for example, an optical guide layer having relatively small band gap energy. For example, in the nitride semiconductor laser element disclosed in PTL 1, the band gap energy is increased by increasing the Al composition ratio of each of semiconductor layers such as the optical guide layer and the cladding layer. Such an increase is intended to reduce optical absorption in each semiconductor layer.

### [Citation List]

### [Patent Literature]

[PTL 1] Japanese Unexamined Patent Application Publication No. 2010-258363

### [Summary of Invention]

### [Technical Problem]

However, when the Al composition ratio of each of semiconductor layers is increased, stress inside a semiconductor structure increases due to a lattice mismatch with a GaN substrate of a nitride semiconductor laser element. For this reason, breaks, cracks, defects, etc. in the semiconductor structure are likely to occur. In addition, the proportion of impurities that serve as acceptors or donors to impurities with which each semiconductor layer is doped decreases by increasing the Al composition ratio of the semiconductor layer. Since electrical resistance in the semiconductor layer increases in association with such a decrease, the operating voltage of the nitride semiconductor laser element increases.

The present disclosure solves such problems and is intended to reduce optical loss while decreasing an Al composition ratio in each of semiconductor layers in a nitride semiconductor light-emitting element that emits light in an ultraviolet range.

### [Solution to Problem]

In order to solve the above problems, a nitride semiconductor light-emitting element according to one aspect of the present disclosure is a nitride semiconductor light-emitting element that emits light, the nitride semiconductor light-emitting element comprising: a substrate: an N-type cladding layer that is disposed above the substrate and includes Al; an N-side optical guide layer that is disposed above the N-type cladding layer and includes Al; an active layer that is disposed above the N-side optical guide layer and includes one or more well layers and a plurality of barrier layers that include Al; an electron blocking layer that is disposed above the active layer and includes Al; a P-type interlayer that is disposed above the electron blocking layer and includes Al; a P-side optical guide layer that is disposed above the P-type interlayer and includes Al; and a P-type cladding layer that is disposed above the P-side optical guide layer and includes Al, wherein average band gap energy of the electron blocking layer is higher than average band gap energy of the P-type cladding layer, wherein average band gap energy of the electron blocking layer is higher than average band gap energy of the P-type cladding layer, an average impurity concentration of the P-type interlayer is lower than an average impurity concentration of the electron blocking layer, and is higher than an average impurity concentration of the P-side optical guide layer, and a peak wavelength of the light is less than 400 nm.

In order to solve the above problems, a nitride semiconductor light-emitting element according to another aspect of the present disclosure is a nitride semiconductor light-emitting element that emits light, the nitride semiconductor light-emitting element comprising: a substrate; an N-type cladding layer that is disposed above the substrate and includes Al; an N-type interlayer that is disposed above the N-type cladding layer and includes Al; an N-side optical guide layer that is disposed above the N-type interlayer and includes Al; an active layer that is disposed above the N-side optical guide layer and includes one or more well layers and a plurality of barrier layers that include Al; a P-side optical guide layer that is disposed above the active layer and includes Al; and a P-type cladding layer that is disposed above the P-side optical guide layer and includes Al, wherein average band gap energy of the N-type interlayer is higher than average band gap energy of the N-side optical guide layer, and is smaller than average band gap energy of the N-type cladding layer, an average impurity concentration of the N-type interlayer is lower than or equal to an average impurity concentration of the N-type cladding layer, and is higher than an average impurity concentration of the N-side optical guide layer, and a peak wavelength of the light is less than 400 nm.

### [Advantageous Effects of Invention]

According to the present disclosure, it is possible to reduce optical loss while decreasing an Al composition ratio in each of semiconductor layers in a nitride semiconductor light-emitting element that emits light in an ultraviolet range.

### [Brief Description of Drawings]

[FIG. 1]

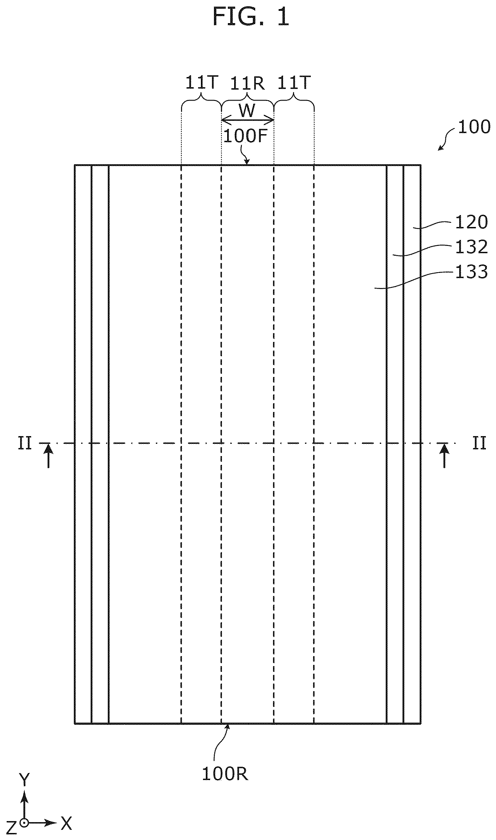

   FIG. 1 is a schematic plan view of the overall configuration of a nitride semiconductor light-emitting element according to Embodiment 1.
[FIG. 2]

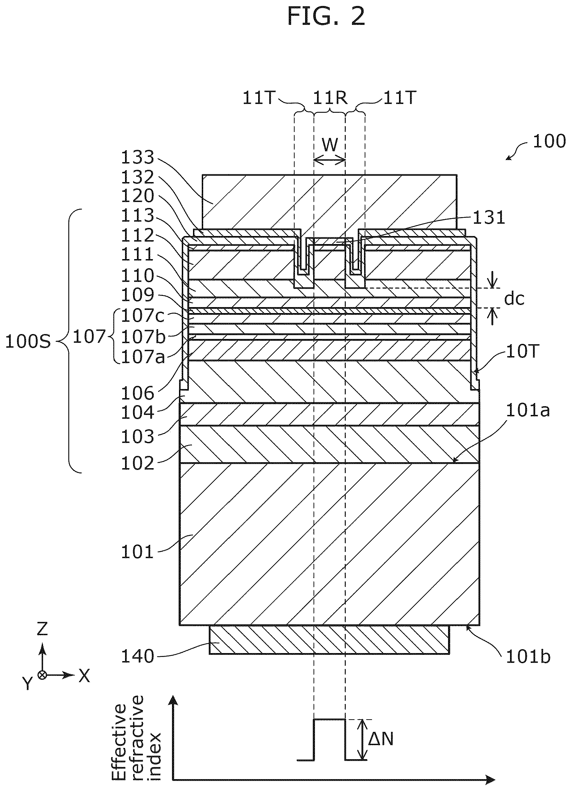

   FIG. 2 is a schematic cross-sectional view of the overall configuration of the nitride semiconductor light-emitting element according to Embodiment 1.
[FIG. 3]

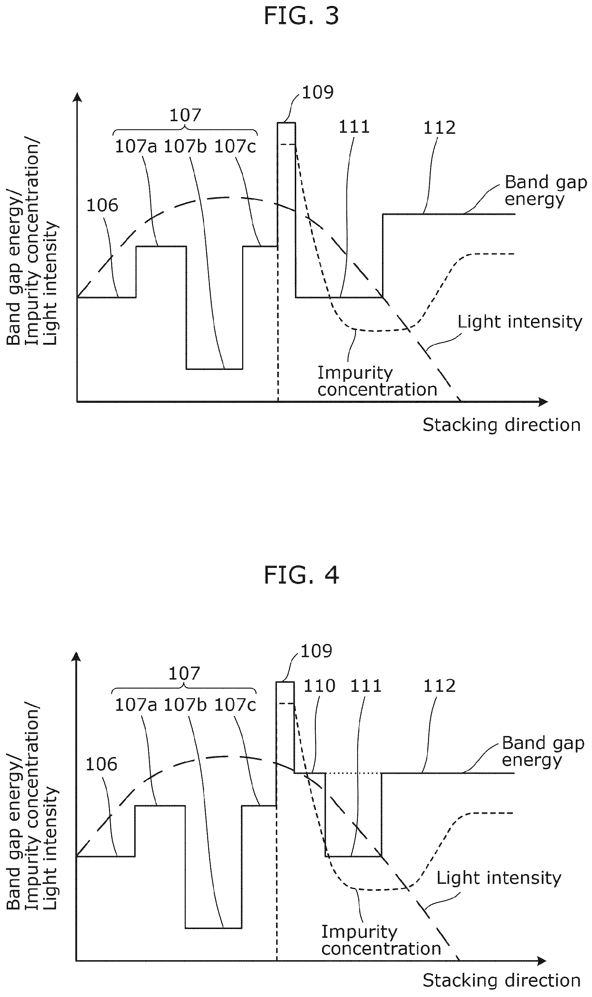

   FIG. 3 is a schematic graph showing a band gap energy distribution and an impurity concentration distribution in a stacking direction, in a nitride semiconductor light-emitting element according to Comparative Example 1.
[FIG. 4]
   FIG. 4 is a schematic graph showing a band gap energy distribution and an impurity concentration distribution in a stacking direction, in the nitride semiconductor light-emitting element according to Embodiment 1.
[FIG. 5]

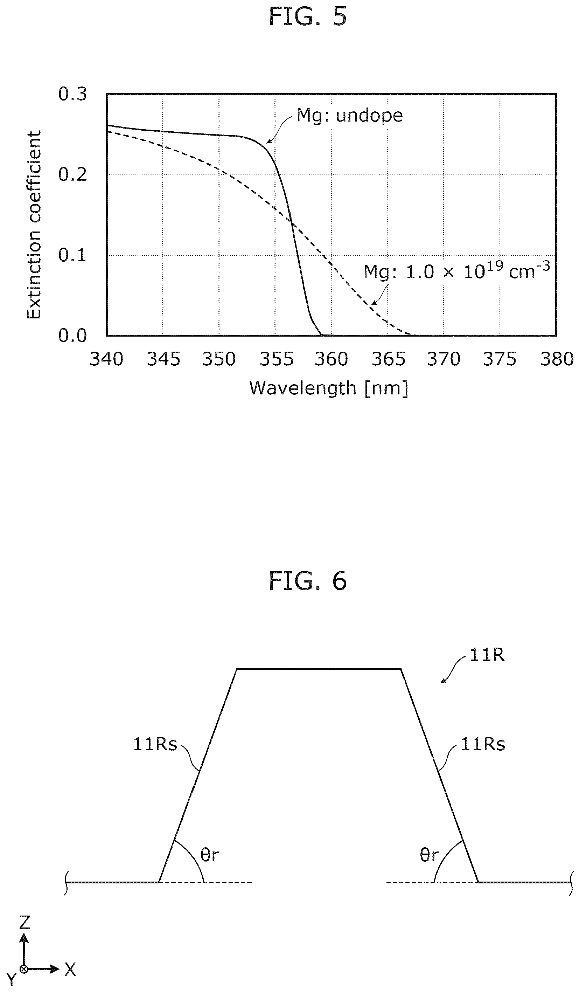

   FIG. 5 is a graph showing extinction coefficient spectra in AlGaN layers.
[FIG. 6]
   FIG. 6 is a schematic cross-sectional diagram illustrating the shape of a lateral face of a ridge according to Embodiment 1.
[FIG. 7]

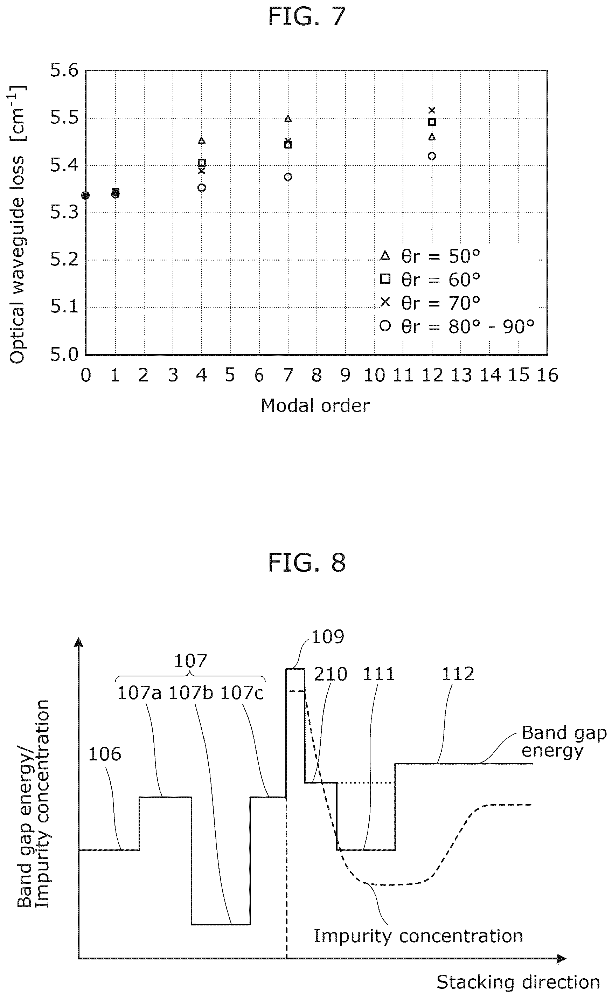

   FIG. 7 is a graph showing a relation between transverse-modal order of laser light and optical waveguide loss in a nitride semiconductor light-emitting element.
[FIG. 8]
   FIG. 8 is a schematic graph showing a band gap energy distribution and an impurity concentration distribution in a stacking direction, in a nitride semiconductor light-emitting element according to Embodiment 2.
[FIG. 9]

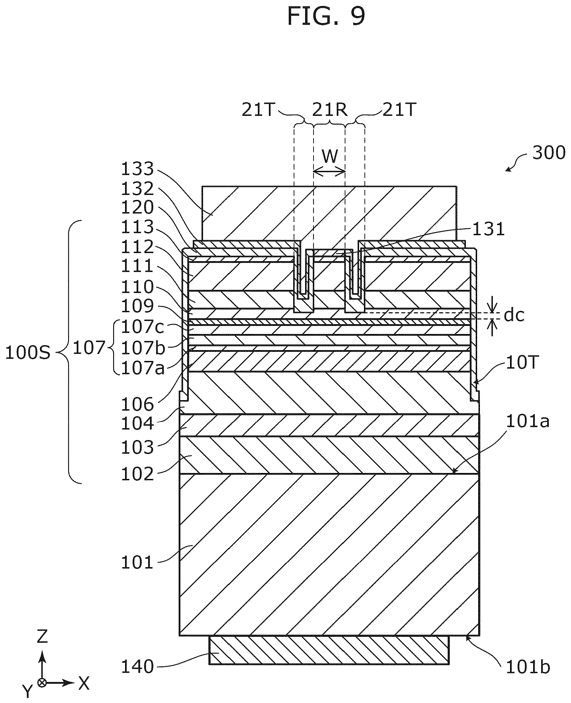

   FIG. 9 is a schematic cross-sectional view of the overall configuration of a nitride semiconductor light-emitting element according to Embodiment 3.
[FIG. 10]

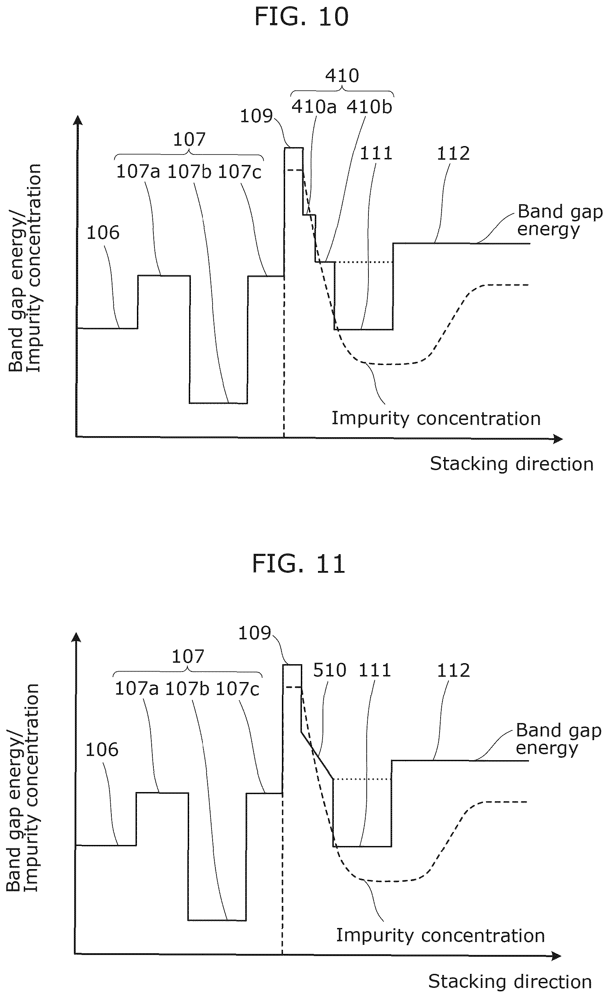

   FIG. 10 is a schematic graph showing a band gap energy distribution and an impurity concentration distribution in a stacking direction, in a nitride semiconductor light-emitting element according to Embodiment 4.
[FIG. 11]
   FIG. 11 is a schematic graph showing a band gap energy distribution and an impurity concentration distribution in a stacking direction, in a nitride semiconductor light-emitting element according to Embodiment 5.
[FIG. 12]

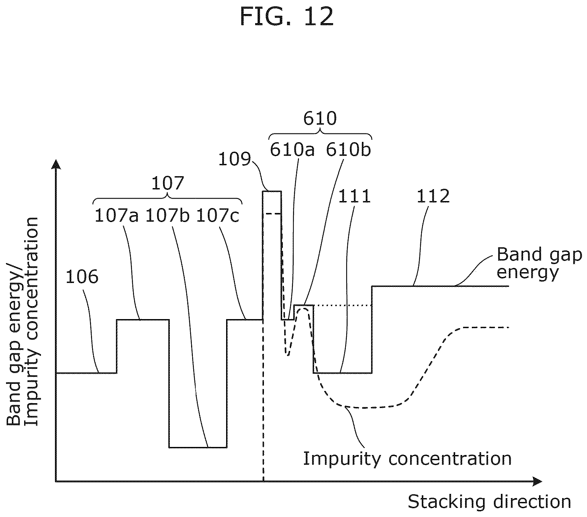

   FIG. 12 is a schematic graph showing a band gap energy distribution and an impurity concentration distribution in a stacking direction, in a nitride semiconductor light-emitting element according to Embodiment 6.
[FIG. 13]

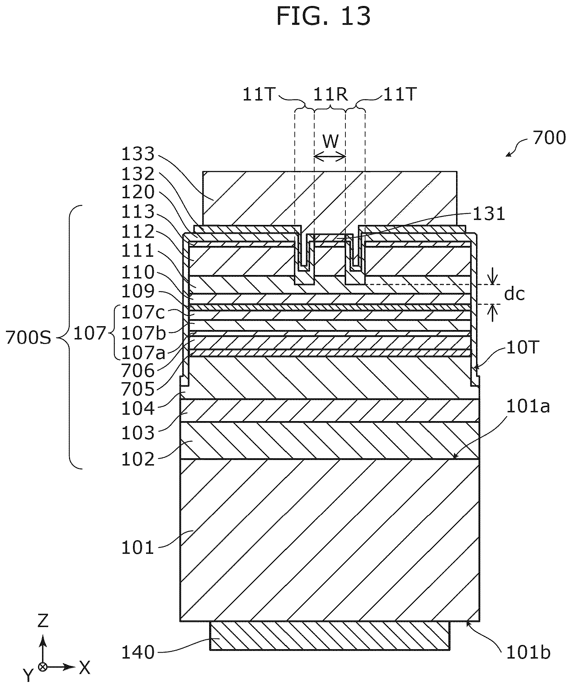

   FIG. 13 is a schematic cross-sectional view of the overall configuration of a nitride semiconductor light-emitting element according to Embodiment 7.
[FIG. 14]

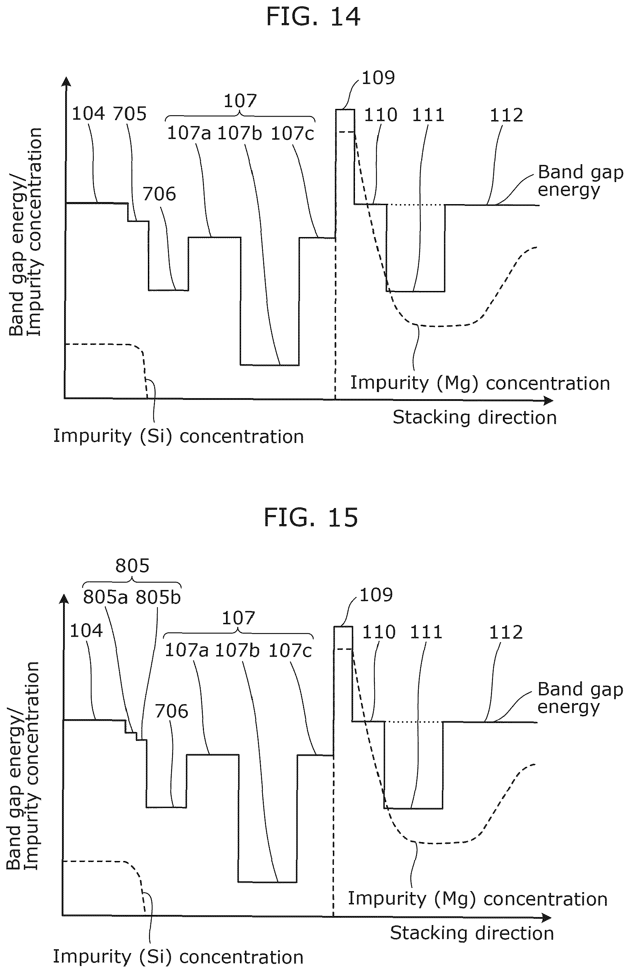

   FIG. 14 is a schematic graph showing a band gap energy distribution and an impurity concentration distribution in a stacking direction, in the nitride semiconductor light-emitting element according to Embodiment 7.
[FIG. 15]
   FIG. 15 is a schematic graph showing a band gap energy distribution and an impurity concentration distribution in a stacking direction, in a nitride semiconductor light-emitting element according to Embodiment 8.
[FIG. 16]

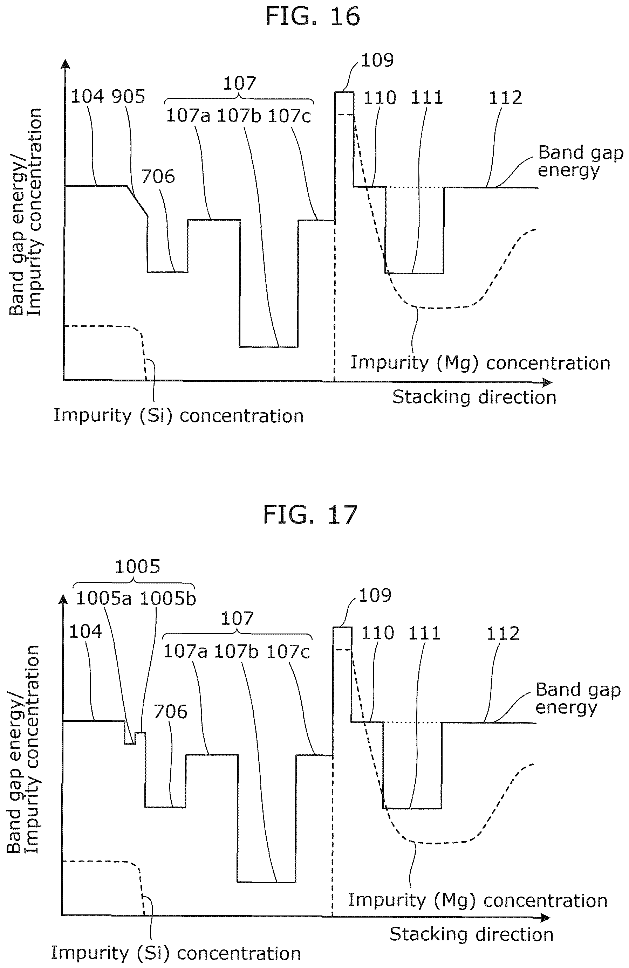

   FIG. 16 is a schematic graph showing a band gap energy distribution and an impurity concentration distribution in a stacking direction, in a nitride semiconductor light-emitting element according to Embodiment 9.
[FIG. 17]
   FIG. 17 is a schematic graph showing a band gap energy distribution and an impurity concentration distribution in a stacking direction, in a nitride semiconductor light-emitting element according to Embodiment 10.
[FIG. 18]

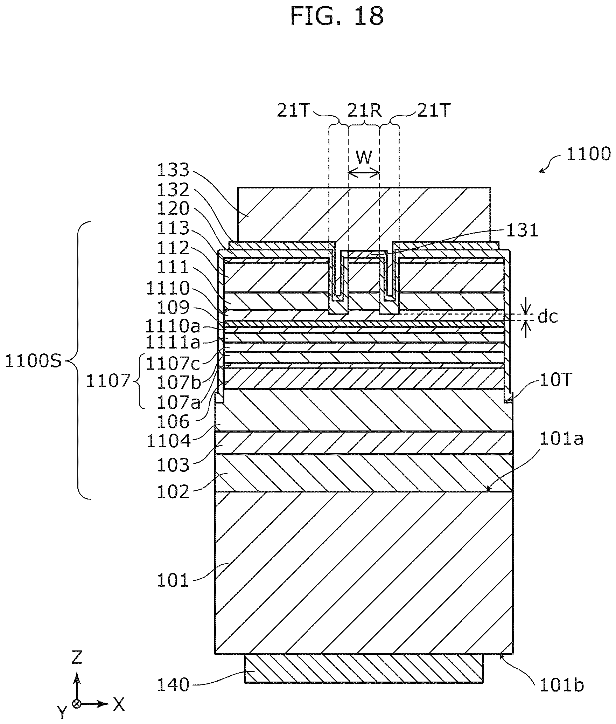

   FIG. 18 is a schematic cross-sectional view of the overall configuration of a nitride semiconductor light-emitting element according to Embodiment 11.
[FIG. 19]

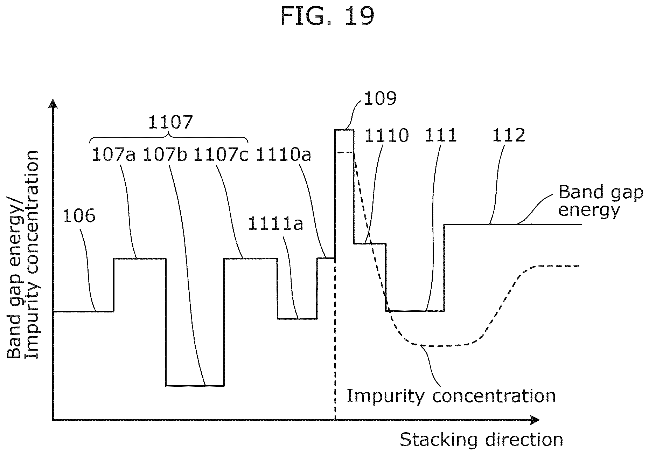

   FIG. 19 is a schematic graph showing a band gap energy distribution and an impurity concentration distribution in a stacking direction, in the nitride semiconductor light-emitting element according to Embodiment 11.
[FIG. 20]

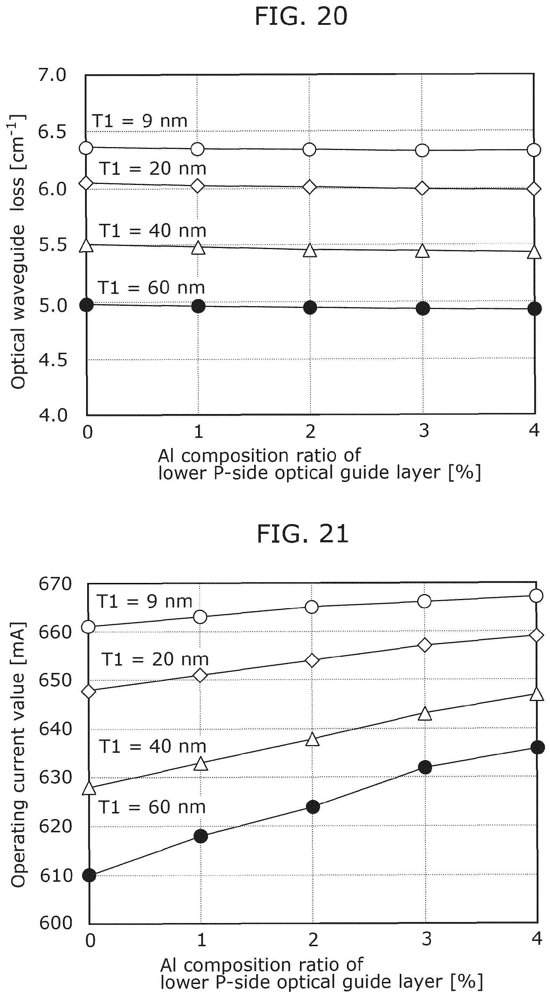

   FIG. 20 is a graph showing a relation between optical waveguide loss and the Al composition ratio of a lower P-side optical guide layer in Configuration Example 1 of the nitride semiconductor light-emitting element according to Embodiment 11.
[FIG. 21]
   FIG. 21 is a graph showing a relation between an operating current when power consumption is 0.5 W and the Al composition ratio of the lower P-side optical guide layer in Configuration Example 1 of the nitride semiconductor light-emitting element according to Embodiment 11.
[FIG. 22]

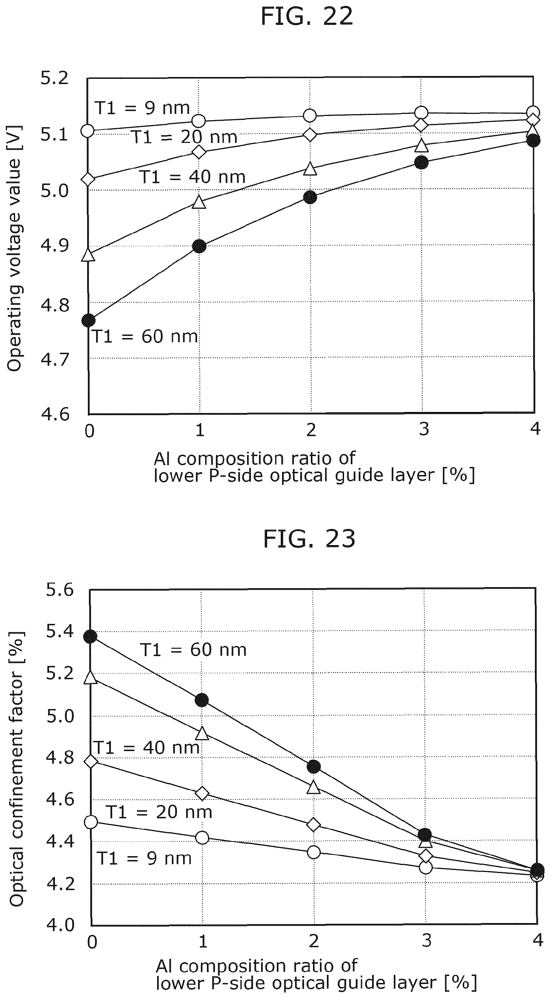

   FIG. 22 is a graph showing a relation between an operating voltage value when power consumption is 0.5 W and the Al composition ratio of the lower P-side optical guide layer in Configuration Example 1 of the nitride semiconductor light-emitting element according to Embodiment 11.
[FIG. 23]
   FIG. 23 is a graph showing a relation between an optical confinement factor and the Al composition ratio of the lower P-side optical guide layer in Configuration Example 1 of the nitride semiconductor light-emitting element according to Embodiment 11.
[FIG. 24]

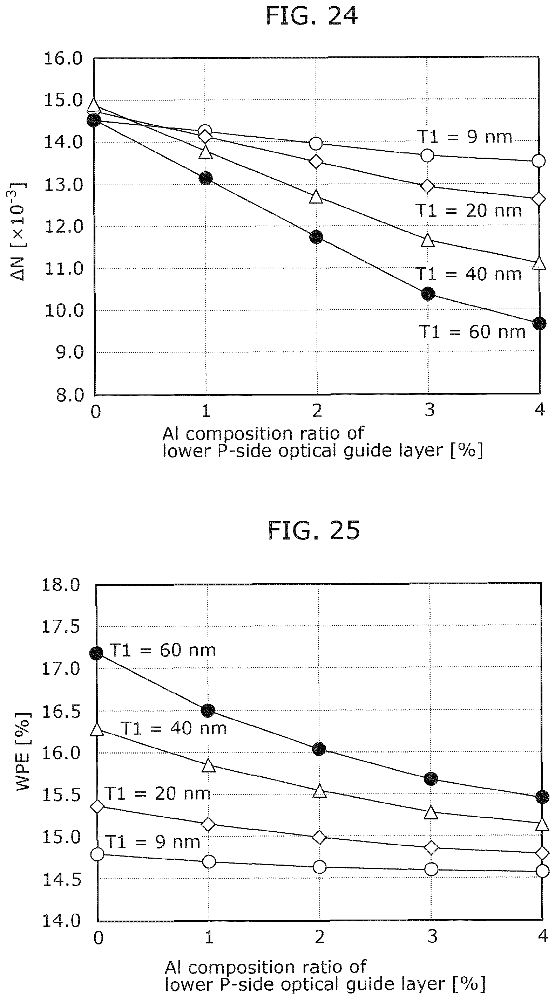

   FIG. 24 is a graph showing a relation between effective refractive index difference ΔN and the Al composition ratio of the lower P-side optical guide layer in Configuration Example 1 of the nitride semiconductor light-emitting element according to Embodiment 11.
[FIG. 25]
   FIG. 25 is a graph showing a relation between WPE when power consumption is 0.5 W and the Al composition ratio of the lower P-side optical guide layer in Configuration Example 1 of the nitride semiconductor light-emitting element according to Embodiment 11.
[FIG. 26]

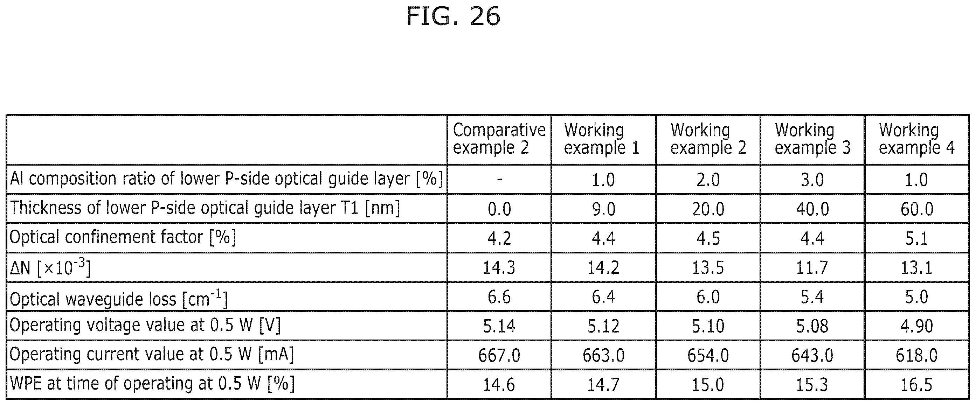

   FIG. 26 is a table showing configurations and characteristics in Working Examples 1 to 4 of the nitride semiconductor light-emitting element according to Embodiment 11.
[FIG. 27]

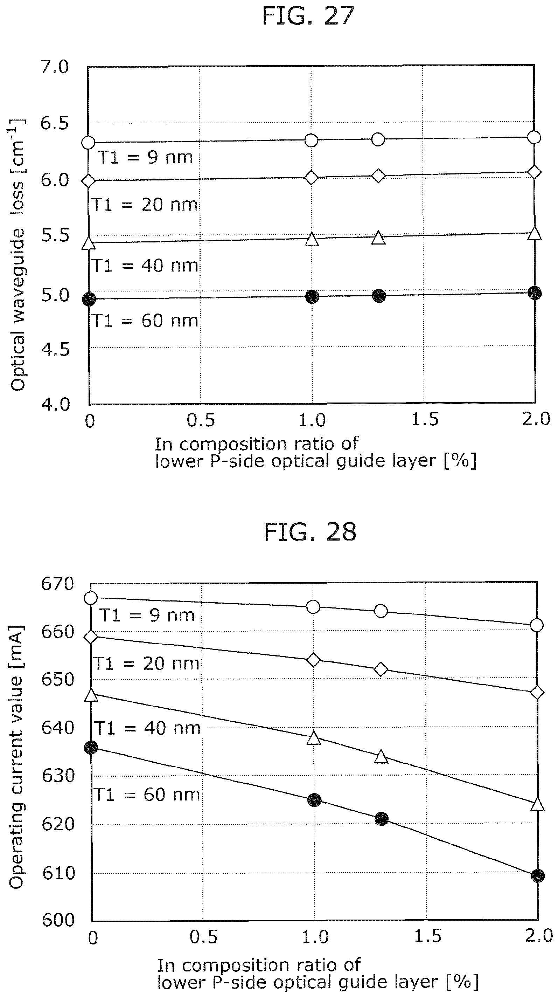

   FIG. 27 is a graph showing a relation between optical waveguide loss and the In composition ratio of a lower P-side optical guide layer in Configuration Example 2 of the nitride semiconductor light-emitting element according to Embodiment 11.
[FIG. 28]
   FIG. 28 is a graph showing a relation between an operating current when power consumption is 0.5 W and the In composition ratio of the lower P-side optical guide layer in Configuration Example 2 of the nitride semiconductor light-emitting element according to Embodiment 11.
[FIG. 29]

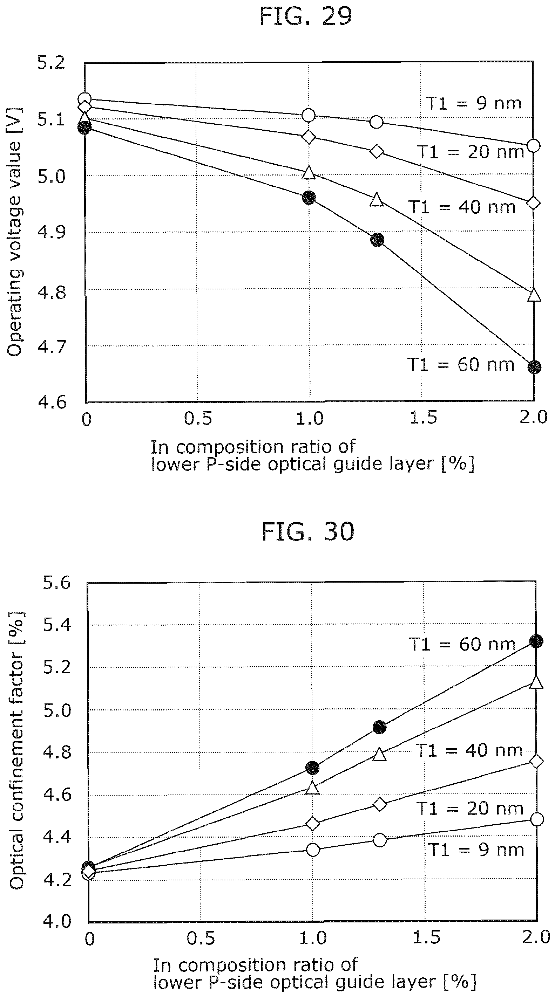

   FIG. 29 is a graph showing a relation between an operating voltage value when power consumption is 0.5 W and the In composition ratio of the lower P-side optical guide layer in Configuration Example 2 of the nitride semiconductor light-emitting element according to Embodiment 11.
[FIG. 30]
   FIG. 30 is a graph showing a relation between an optical confinement factor and the In composition ratio of the lower P-side optical guide layer in Configuration Example 2 of the nitride semiconductor light-emitting element according to Embodiment 11.
[FIG. 31]

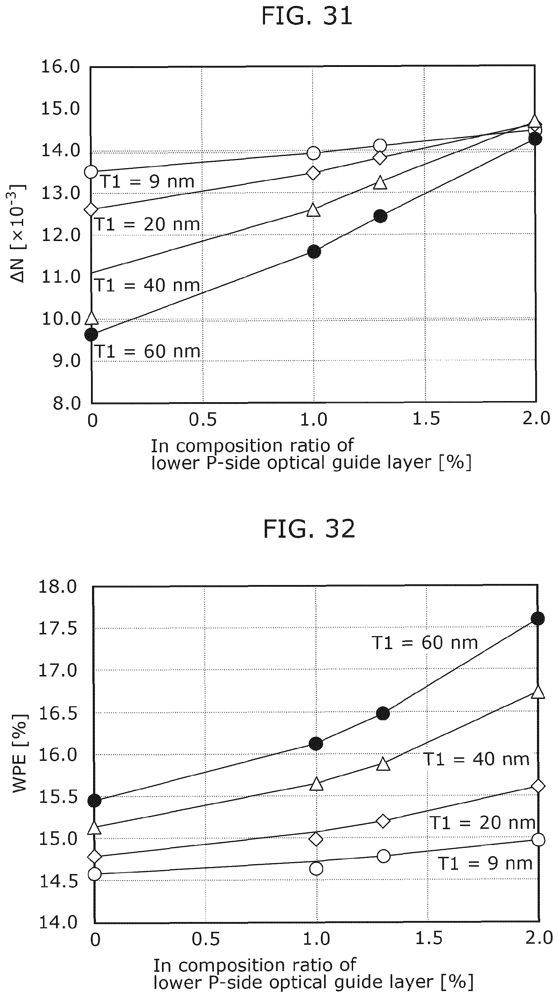

   FIG. 31 is a graph showing a relation between effective refractive index difference ΔN and the In composition ratio of the lower P-side optical guide layer in Configuration Example 2 of the nitride semiconductor light-emitting element according to Embodiment 11.
[FIG. 32]
   FIG. 32 is a graph showing a relation between WPE when power consumption is 0.5 W and the In composition ratio of the lower P-side optical guide layer in Configuration Example 2 of the nitride semiconductor light-emitting element according to Embodiment 11.
[FIG. 33]

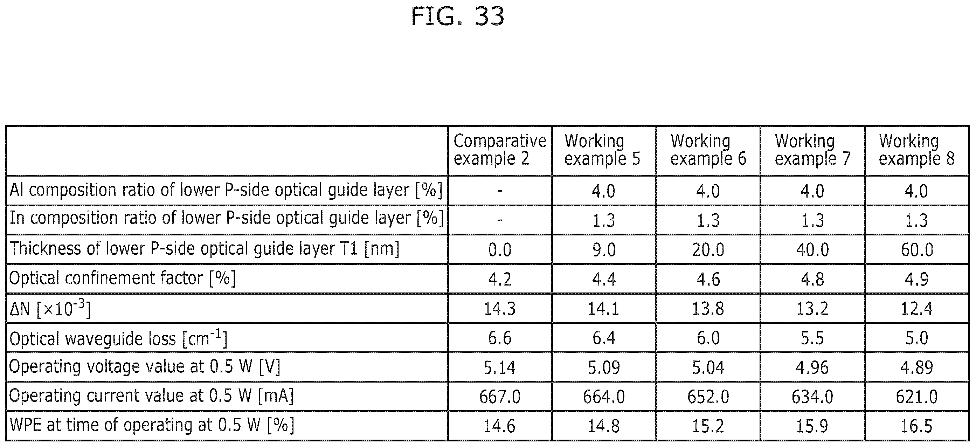

   FIG. 33 is a table showing configurations and characteristics in Working Examples 5 to 8 of the nitride semiconductor light-emitting element according to Embodiment 11.

### [Description of Embodiments]

Hereinafter, embodiments of the present disclosure are described with reference to the Drawings. It should be noted that the embodiments described below each show a specific example of the present disclosure. Accordingly, the numerical values, shapes, materials, constituent elements, the arrangement and connection of the constituent elements, etc. indicated in the following embodiments are mere examples and are not intended to limit present disclosure.

Moreover, the respective figures are schematic drawings and are not necessarily precise illustrations. Accordingly, the figures are not necessarily to scale etc. It should be noted that the same reference signs are assigned to substantially identical elements in the respective figures, and overlapping descriptions thereof are omitted or simplified.

Furthermore, in this Description, terms indicating the relationship between elements such as equal, terms indicating the shape of elements such as flat, parallel, perpendicular, plate-like shape, or curved surface shape, and numerical ranges are not expressions that indicate only the strict meaning but are expressions that mean a substantially equivalent range, and include, for example, an error of approximately several percent.

Moreover, in this Description, the terms "above" and "below" do not refer to the upward (vertically upward) direction and downward (vertically downward) direction in terms of absolute spatial recognition, and are used as terms defined by relative positional relationships based on the stacking order of a stacked configuration. In addition, the terms "above" and "below" are applied not only when two constituent elements are arranged at intervals without another constituent element located between the two constituent elements, but also when two constituent elements are arranged adjacent to each other.

### [Embodiment 1]

A nitride semiconductor light-emitting element according to Embodiment 1 is described below.

### [1-1. Overall Configuration]

First, the overall configuration of the nitride semiconductor light-emitting element according to the present embodiment is described with reference to FIG. 1 and FIG. 2. FIG. 1 and FIG. 2 are a schematic plan view and a cross-sectional view of the overall configuration of nitride semiconductor light-emitting element 100 according to the present embodiment, respectively. FIG. 2 shows a cross section taken along line II-II shown in FIG. 1. It should be noted that each of the figures shows an X axis, a Y axis, and a Z axis that are orthogonal to each other. The X axis, the Y axis, and the Z axis constitute a right-handed orthogonal coordinate system. The stacking direction of nitride semiconductor light-emitting element 100 is parallel to a Z-axis direction, and the main emission direction of light (laser light) is parallel to a Y-axis direction.

Nitride semiconductor light-emitting element 100 includes semiconductor structure 100S containing nitride semiconductor layers as shown in FIG. 2, and emits light through end face 100F (see FIG. 1) in a direction perpendicular to the stacking direction of semiconductor structure 100S (i.e., the Z-axis direction). In the present embodiment, nitride semiconductor light-emitting element 100 is a semiconductor laser element that includes two end faces 100F and 100R that constitute an optical cavity. End face 100F is a front end face through which laser light is emitted, and end face 100R is a rear end face that has a higher reflective index than end face 100F. In addition, nitride semiconductor light-emitting element 100 includes a waveguide provided between end face 100F and end face 100R. Although not particularly limited, reflective indexes of end faces 100F and 100R are 16% and 95% in the present embodiment, respectively. The optical cavity length of nitride semiconductor light-emitting element 100 according to the present embodiment (i.e., a distance between end face 100F and end face 100R) is approximately 800 µm. The peak wavelength of light emitted by nitride semiconductor light-emitting element 100 is less than 400 nm. Nitride semiconductor light-emitting element 100 emits, for example, ultraviolet light that has a peak wavelength in the 375-nm band. It should be noted that nitride semiconductor light-emitting element 100 may emit ultraviolet light that has a peak wavelength in a band other than the 375-nm band.

As shown in FIG. 2, nitride semiconductor light-emitting element 100 includes substrate 101, semiconductor structure 100S, current blocking layer 120, P-side electrode 131, adhesion layer 132, pad electrode 133, and N-side electrode 140. Semiconductor structure 100S includes foundation layer 102, buffer layer 103, N-type cladding layer 104, N-side optical guide layer 106, active layer 107, electron blocking layer 109, P-type interlayer 110, P-side optical guide layer 111, P-type cladding layer 112, and contact layer 113. Element isolation trench 10T is provided in a lateral face of semiconductor structure 100S (an end face in the X-axis direction). Element isolation trench 10T is a trench for dicing nitride semiconductor light-emitting element 100.

Substrate 101 is a plate-shaped component that includes a nitride semiconductor that serves as a base for nitride semiconductor light-emitting element 100. Substrate 101 includes principal faces 101a and 101b. In the present embodiment, substrate 101 is disposed below N-type cladding layer 104 and includes N-type GaN. More specifically, substrate 101 is a GaN substrate that is doped with Si at an average concentration of 1.4 × 10¹⁸ cm⁻³ and has a thickness of 85 µm.

Foundation layer 102 is an N-type nitride semiconductor layer that is disposed above substrate 101. Foundation layer 102 may have a lower average Al composition ratio than N-type cladding layer 104. In the present embodiment, foundation layer 102 is an N-type Al_{0.02}Ga_{0.98}N layer that is disposed on principal face 101a of substrate 101, doped with Si at an average concentration of 1.0 × 10¹⁸ cm⁻³, and has a thickness of 1000 nm.

In the present disclosure, the average concentration of impurities (i.e., an average impurity concentration) in each layer refers to an average impurity concentration value that is obtained by (i) integrating, in the stacking direction of the layer, the magnitude of an impurity concentration at a position in the stacking direction from the position of an interface on a side closer to substrate 101 to the position of an interface on a side farther from substrate 101 in the stacking direction and (ii) dividing the integral value by the thickness of the layer (a distance between the interface on the side closer to substrate 101 and the interface on the side farther from substrate 101). For an N-type semiconductor layer, impurities refer to impurities used for doping to achieve an N conductivity type. For a P-type semiconductor layer, impurities refer to impurities used for doping to achieve a P conductivity type.

The average Al composition ratio of a layer refers to an Al composition ratio value that is obtained by (i) integrating, in the stacking direction of the layer, the magnitude of an Al composition ratio at a position in the stacking direction from the position of an interface on the side closer to substrate 101 in the stacking direction to the position of an interface on the side farther from substrate 101 and (ii) dividing the integral value by the thickness of the layer.

Buffer layer 103 is an N-type nitride semiconductor layer that is disposed between substrate 101 and N-type cladding layer 104. In the present embodiment, buffer layer 103 is disposed on foundation layer 102. In the present embodiment, buffer layer 103 includes: an N-type GaN layer that is doped with Si at an average concentration of 1.0 × 10¹⁸ cm⁻³ and has a thickness of 10 nm; an N-type In_{0.04}Ga_{0.96}N layer that is disposed above the N-type GaN layer, doped with Si at the average concentration of 1.0 × 10¹⁸ cm⁻³, and has a thickness of 150 nm; and an N-type GaN layer that is disposed above the N-type In_{0.04}Ga_{0.96}N layer, doped with Si at the average concentration of 1.0 × 10¹⁸ cm⁻³, and has a thickness of 10 nm.

N-type cladding layer 104 is an N-type nitride semiconductor layer that is disposed above substrate 101 and includes Al. In the present embodiment, N-type cladding layer 104 is disposed on buffer layer 103. N-type cladding layer 104 has a lower average refractive index and higher average band gap energy than active layer 107. In addition, N-type cladding layer 104 has a lower average refractive index and higher average band gap energy than N-side optical guide layer 106. The average Al composition ratio of N-type cladding layer 104 is higher than the average Al composition ratio of N-side optical guide layer 106. The average Al composition ratio of N-type cladding layer 104 may be less than 10%. In the present embodiment, N-type cladding layer 104 is an N-type Al_{0.065}Ga_{0.935}N layer that is doped with Si at an average concentration of 1.0 × 10¹⁸ cm⁻³ and has a thickness of 900 nm.

In the present disclosure, the average band gap energy of a layer refers to a band gap energy value that is obtained by (i) integrating, in the stacking direction of the layer, the amount of band gap energy at a position in the stacking direction from the position of an interface on the side closer to substrate 101 to the position of an interface on the side farther from substrate 101 in the stacking direction and (ii) dividing the integrated amount of the band gap energy by the thickness of the layer.

Additionally, the average refractive index of a layer refers to a refractive index value that is obtained by (i) integrating, in the stacking direction of the layer, the magnitude of a refractive index at a position in the stacking direction from the position of an interface on the side closer to substrate 101 to the position of an interface on the side farther from substrate 101 in the stacking direction and (ii) dividing the integrated magnitude of the refractive indexes by the thickness of the layer.

N-side optical guide layer 106 is a nitride semiconductor layer that is disposed above N-type cladding layer 104 and includes Al. N-side optical guide layer 106 has a higher average refractive index and smaller average band gap energy than N-type cladding layer 104. The average Al composition ratio of N-side optical guide layer 106 may be less than 10%. In the present embodiment, N-side optical guide layer 106 includes: an N-type Al_{0.03}Ga_{0.97}N layer that is doped with Si at an average concentration of 1.0 × 10¹⁸ cm⁻³ and has a thickness of 127 nm; and an undoped Al_{0.03}Ga_{0.97}N layer that is disposed above the N-type Al_{0.03}Ga_{0.97}N layer and has a thickness of 80 nm. In the present disclosure, an undoped layer means a semiconductor layer that has an impurity concentration less than 1.0 × 10¹⁸ cm⁻³.

Active layer 107 is a nitride semiconductor layer that is disposed above N-side optical guide layer 106 and includes well layer 107b and barrier layers 107a and 107c that include Al. Well layer 107b is disposed between barrier layer 107a and barrier layer 107c. In the present embodiment, active layer 107 emits ultraviolet light. It should be noted that the configuration of active layer 107 is not limited to the above example. For example, active layer 107 may have a multiple quantum well structure. Specifically, active layer 107 may include three or more barrier layers and two or more well layers. In other words, active layer 107 includes one or more well layers and a plurality of barrier layers.

Each of barrier layers 107a and 107c is a nitride semiconductor layer that is disposed above N-side optical guide layer 106 and serves as a barrier for a quantum well structure. Barrier layer 107c is disposed above barrier layer 107a. In the present embodiment, the average band gap energy of each of barrier layers 107a and 107c is higher than the average band gap energy of well layer 107b. In the present embodiment, barrier layer 107a is an undoped Al_{0.04}Ga_{0.96}N layer that has a thickness of 14 nm. Barrier layer 107c is an undoped Al_{0.04}Ga_{0.96}N layer that has a thickness of 12 nm.

Well layer 107b is a nitride semiconductor layer that is disposed above barrier layer 107a and serves as a well for the quantum well structure. In the present embodiment, well layer 107b is an undoped In_{0.01}Ga_{0.99}N layer that has a thickness of 17.5 nm.

Electron blocking layer 109 is a P-type nitride semiconductor layer that is disposed above active layer 107 and includes Al. The average band gap energy of electron blocking layer 109 is higher than the average band gap energy of barrier layer 107c. For this reason, it is possible to reduce leakage of electrons from active layer 107 to P-type cladding layer 112. In the present embodiment, the average band gap energy of electron blocking layer 109 is higher than the average band gap energy of each of P-type interlayer 110 and P-type cladding layer 112. The average impurity concentration of electron blocking layer 109 is higher than the average impurity concentration of each of P-type interlayer 110 and P-side optical guide layer 111. In the present embodiment, electron blocking layer 109 is a P-type Al_{0.36}Ga_{0.64}N layer that is doped with Mg at an average concentration of 1.5 × 10¹⁹ cm⁻³ and has a thickness of 1.6 nm.

P-type interlayer 110 is a P-type nitride semiconductor layer that is disposed above electron blocking layer 109 and includes Al. The average impurity concentration of P-type interlayer 110 is lower than the average impurity concentration of electron blocking layer 109, and is higher than the average impurity concentration of P-side optical guide layer 111. The average Al composition ratio of P-type interlayer 110 may be less than 10%. In addition, the thickness of P-type interlayer 110 may be greater than the thickness of electron blocking layer 109. In the present embodiment, P-type interlayer 110 is a P-type Al_{0.065}Ga_{0.933}N layer that is doped with Mg at an average concentration of 1.0 × 10¹⁹ cm⁻³ and has a thickness of 20 nm.

P-side optical guide layer 111 is a nitride semiconductor layer that is disposed above electron blocking layer 109 and includes Al. In the present embodiment, P-side optical guide layer 111 is disposed above P-type interlayer 110. P-side optical guide layer 111 has a higher average refractive index and smaller average band gap energy than P-type cladding layer 112. In the present embodiment, the average band gap energy of P-side optical guide layer 111 is smaller than the average band gap energy of each of P-type interlayer 110 and P-type cladding layer 112. The average Al composition ratio of P-side optical guide layer 111 may be less than 10%. In the present embodiment, P-side optical guide layer 111 is a P-type Al_{0.03}Ga_{0.97}N layer that is doped with Mg at an average concentration of 2.0 × 10¹⁸ cm⁻³ and has a thickness of 110 nm.

P-type cladding layer 112 is a P-type nitride semiconductor layer that is disposed above P-side optical guide layer 111 and includes Al. P-type cladding layer 112 has a lower average refractive index and higher average band gap energy than active layer 107. The average band gap energy of P-type cladding layer 112 is smaller than the average band gap energy of electron blocking layer 109. The average Al composition ratio of P-type cladding layer 112 may be less than 10%. An impurity concentration in an end portion of P-type cladding layer 112 on a side closer to active layer 107 may be lower than an impurity concentration in an end portion of P-type cladding layer 112 on a side farther from active layer 107. Since this makes it possible to decrease an impurity concentration in a region that has a high light intensity in P-type cladding layer 112, it is possible to reduce free carrier loss of light caused by impurities. In the present embodiment, P-type cladding layer 112 includes: a P-type Al_{0.065}Ga_{0.935}N layer that is doped with Mg at an average concentration of 2.0 × 10¹⁸ cm⁻³ and has a thickness of 170 nm; and a P-type Al_{0.065}Ga_{0.935}N layer that is disposed on the P-type Al_{0.065}Ga_{0.935}N layer, doped with Mg at an average concentration of 1.0 × 10¹⁹ cm⁻³, and has a thickness of 300 nm.

Contact layer 113 is a P-type nitride semiconductor layer that is disposed above P-type cladding layer 112 and in ohmic contact with P-side electrode 131. In the present embodiment, contact layer 113 includes: a P-type GaN layer that is doped with Mg at an average concentration of 2.0 × 10¹⁹ cm⁻³ and has a thickness of 50 nm; and a P-type GaN layer that is disposed above the P-type GaN layer, doped with Mg at an average concentration of 2.0 × 10²⁰ cm⁻³, and has a thickness of 10 nm.

Ridge 11R is provided in contact layer 113 and P-type cladding layer 112. In the present embodiment, ridge 11R is provided in contact layer 113, P-type cladding layer 112, and P-side optical guide layer 111. In addition, two trenches 11T that are disposed along ridge 11R and extend in the Y-axis direction are provided in contact layer 113, P-type cladding layer 112, and P-side optical guide layer 111. In the present embodiment, ridge width W is approximately 15 µm. Additionally, as shown in FIG. 2, a distance between a lower end portion of ridge 11R (i.e., a bottom portion of trench 11T) and electron blocking layer 109 is denoted by dc. In the present embodiment, distance dc is 35 nm. In other words, P-type interlayer 110 having the thickness of 20 nm and a lower portion of P-side optical guide layer 111 having the thickness of 110 nm are located between the lower end portion of ridge 11R and electron blocking layer 109, and an upper portion of P-side optical guide layer 111 is located in ridge 11R, the lower portion having a thickness of 15 nm, the upper portion having a thickness of 95 nm.

Current blocking layer 120 is an insulating layer that is disposed above P-type cladding layer 112 and is transmissive to light from active layer 107. Current blocking layer 120 is disposed in a region of the top face of semiconductor structure 100S other than the top face of ridge 11R. It should be noted that current blocking layer 120 may be disposed in a portion of a region of the top face of ridge 11R. For example, current blocking layer 120 may be disposed in an end edge region of the top face of ridge 11R. In the present embodiment, current blocking layer 120 is a SiO₂ layer having a thickness of 300 nm.

P-side electrode 131 is a conductive layer that is disposed above contact layer 113. In the present embodiment, P-side electrode 131 is in contact with contact layer 113. P-side electrode 131 is a single film or a multifilm that includes at least one of, for example, Cr, Ti, Ni, Pd, Pt, Ag, or Au. Moreover, since it is possible to minimize leakage of light propagating through a waveguide to P-side electrode 131 by using Ag having a low refractive index for light in a 375-nm wavelength band for at least a portion of P-side electrode 131, it is possible to reduce optical waveguide loss that occurs in P-side electrode 131. Ag has a refractive index of at most 0.5 in a wavelength range from at least 325 nm to at most 1500 nm, and has a refractive index of at most 0.2 in a wavelength range from 360 nm to 950 nm. In this case, since P-side electrode 131 includes Ag, it is possible to reduce optical loss in P-side electrode 131 in a wide wavelength range from at least 325 nm to at most 950 nm. In this case, since it is possible to minimize the leakage of the light propagating through the waveguide to P-side electrode 131 even when the thickness of P-type cladding layer 112 is at most 400 nm, it is possible to reduce an increase in optical waveguide loss while reducing the series resistance of nitride semiconductor light-emitting element 100. As a result, it is possible to decrease the operating voltage and the operating current. In the present embodiment, P-side electrode 131 includes: a Pd layer that has a thickness of 40 nm; and a Pt layer that is disposed on the Pd layer and has a thickness of 100 nm.

The thickness of P-type cladding layer 112 may be greater than a total thickness of optical guide layers on the P side (the thickness of P-side optical guide layer 111 in the present embodiment), and greater than a total thickness of optical guide layers on the N side (the thickness of N-side optical guide layer 106 in the present embodiment). Since this allows the thickness of P-type cladding layer 112 to be sufficient to confine light below P-side electrode 131, it is possible to reduce the optical waveguide loss. In addition, when P-side electrode 131 includes Ag, the thickness of P-type cladding layer 112 may be, for example, at least 200 nm and at most 400 nm. For this reason, it is possible to decrease the operating voltage and the operating current while reducing the optical waveguide loss.

Furthermore, a layer that has a high Al composition ratio such as P-type cladding layer 112 has a large strain relative to substrate 101 including N-type GaN. Since it is possible to reduce a total Al content in P-type cladding layer 112 by decreasing the thickness of P-type cladding layer 112, it is possible to reduce a strain relative to substrate 101 in P-type cladding layer 112. Accordingly, it is possible to reduce cracks in nitride semiconductor light-emitting element 100 caused by the strain in P-type cladding layer 112.

In order to confine the light propagating through the waveguide in ridge 11R, as will be described later, it is necessary to make an effective refractive index difference (ΔN) to cause an effective refractive index value of an inner region of ridge 11R to be higher than an effective refractive index value of an outer region of ridge 10R (see FIG. 2). Specifically, it is necessary to provide SiO₂ that has a lower refractive index than P-type cladding layer 112 in a lateral wall of ridge 11R, and decrease the effective refractive index of the outer region of ridge 10R. In this case, since a region in which SiO₂ is provided becomes smaller in the thickness direction of the lateral wall of ridge 11R when the thickness of P-type cladding layer 112 is excessively reduced, an effect of reducing the effective refractive index of the outer region of ridge 11R is reduced. For this reason, the thickness of P-type cladding layer 112 need be at least 0.15 µm.

Adhesion layer 132 is a metal layer that is disposed between current blocking layer 120 and pad electrode 133. Adhesion layer 132 serves to enhance adhesion of pad electrode 133. It should be noted that adhesion layer 132 may be disposed on P-side electrode 131. In the present embodiment, adhesion layer 132 includes: a Ti layer that is disposed on current blocking layer 120 and has a thickness of 10 nm; and a Pt layer that is disposed on the Ti layer and has a thickness of 100 nm.

Pad electrode 133 is a pad-shaped electrode that is disposed above P-side electrode 131. In the present embodiment, pad electrode 133 is disposed above P-side electrode 131 and adhesion layer 132. In the present embodiment, pad electrode 133 is an Au layer that has a thickness of 2.0 µm.

N-side electrode 140 is a conductive layer that is disposed below substrate 101 (i.e., on principal face 101b opposite principal face 101a of substrate 101 on which N-type cladding layer 104 etc. is disposed). N-side electrode 140 is a single film or a multifilm that includes at least one of, for example, Cr, Ti, Ni, Pd, Pt, or Au. In the present embodiment, N-side electrode 140 includes: a Ti layer that has a thickness of 10 nm; a Pt layer that has a thickness of 50 nm; and an Au film that has a thickness of 300 nm. These layers and film are stacked in stated order from substrate 101.

### [1-2. Advantageous Effects]

Advantageous effects achieved by nitride semiconductor light-emitting element 100 according to the present embodiment are described with reference to FIG. 3 to FIG. 5 while being compared with those achieved by a nitride semiconductor light-emitting element according to Comparative Example 1. FIG. 3 and FIG. 4 each are a schematic graph showing a band gap energy distribution and an impurity concentration distribution in a stacking direction, in a corresponding one of the nitride semiconductor light-emitting elements according to Comparative Example 1 and the present embodiment. It should be noted that FIG. 3 and FIG. 4 also show an intensity distribution of light propagating through nitride semiconductor light-emitting element 100. FIG. 5 is a graph showing extinction coefficient spectra in AlGaN layers. In FIG. 5, extinction coefficient spectra of an undoped Al_{0.03}Ga_{0.97}N layer and an Al_{0.03}Ga_{0.97}N layer that is doped with Mg at an average concentration of 1.0 × 10¹⁹ cm⁻³ are indicated by the solid line and the dashed line, respectively.

The nitride semiconductor light-emitting element according to Comparative Example 1 differs from nitride semiconductor light-emitting element 100 according to the present embodiment in not including P-type interlayer 110, and is identical in other respects to nitride semiconductor light-emitting element 100.

Each of the nitride semiconductor light-emitting elements according to Comparative Example 1 and the present embodiment includes electron blocking layer 109 that has high band gap energy. Such electron blocking layer 109 is doped with highly concentrated impurities (Mg) to reduce electrical resistance in electron blocking layer 109. Concomitantly, in a process of manufacturing each nitride semiconductor light-emitting element, impurities that remain in a chamber used for stacking are doped into a layer that is stacked following a process of stacking electron blocking layer 109. For this reason, as shown in FIG. 3, in the nitride semiconductor light-emitting element according to Comparative Example 1, impurities having a concentration higher than a designed impurity concentration of P-side optical guide layer 111 are doped into P-side optical guide layer 111 that is stacked on electron blocking layer 109. In particular, an impurity concentration is high in a region of P-side optical guide layer 111 in the vicinity of electron blocking layer 109.

As shown in FIG. 5, in an AlGaN layer such as P-side optical guide layer 111, an optical absorption edge (an edge of an optical absorption wavelength band on a long-wavelength side) shifts to a low energy side (i.e., shifts to the long-wavelength side) due to the influence of an impurity level. In addition, the amount of the shift to the low energy side increases with an increase in impurity concentration. For this reason, in an AlGaN layer that has a relatively low average Al composition ratio such as P-side optical guide layer 111, the influence of optical absorption (i.e., optical loss) due to the increase in impurity concentration becomes prominent.

In contrast, nitride semiconductor light-emitting element 100 according to the present embodiment includes, on electron blocking layer 109, P-type interlayer 110 that has smaller average band gap energy than electron blocking layer 109, and higher average band gap energy than P-side optical guide layer 111. The average impurity concentration of P-type interlayer 110 is lower than the average impurity concentration of electron blocking layer 109, and is higher than the average impurity concentration of P-side optical guide layer 111.

As stated above, since nitride semiconductor light-emitting element 100 according to the present embodiment includes, in a region that is on electron blocking layer 109 and in which an impurity concentration is high, P-type interlayer 110 that has the higher average band gap energy than P-side optical guide layer 111, it is possible to shift an optical absorption edge in the region to a high energy side (a short-wavelength side), compared with the nitride semiconductor light-emitting element according to Comparative Example 1. Accordingly, nitride semiconductor light-emitting element 100 according to the present embodiment makes it possible to reduce optical absorption in the region, compared with the nitride semiconductor light-emitting element according to Comparative Example 1. As stated above, nitride semiconductor light-emitting element 100 according to the present embodiment makes it possible to reduce the optical loss while decreasing the Al composition ratio of each of the layers such as P-side optical guide layer 111 and P-type cladding layer 112.

Moreover, in nitride semiconductor light-emitting element 100, the average band gap energy of P-type interlayer 110 may be higher than or equal to the average band gap energy of P-type cladding layer 112.

According to this configuration, since it is possible to shift the optical absorption edge in P-type interlayer 110 further to the high energy side, it is possible to further reduce the optical loss in P-type interlayer 110.

Furthermore, in nitride semiconductor light-emitting element 100, the thickness of P-type interlayer 110 may be at least 10 nm.

In a region that is spaced at least a certain distance apart from electron blocking layer 109 in an upward direction, the influence of residual impurities is reduced. For example, in a region that is spaced at least 10 nm apart from electron blocking layer 109 in the upward direction, it is possible to decrease an impurity concentration by at least 20% relative to an impurity concentration in an upper interface of electron blocking layer 109. Accordingly, since the thickness of P-type interlayer 110 is at least 10 nm, it is possible to reduce optical loss caused by the residual impurities.

Additionally, in a region that is spaced at least 20 nm apart from electron blocking layer 109 in the upward direction, it is possible to decrease an impurity concentration to less than or equal to half of the impurity concentration in the upper interface of electron blocking layer 109.

Accordingly, since the thickness of P-type interlayer 110 is at least 20 nm, it is possible to sufficiently reduce optical loss caused by the residual impurities.

Moreover, in nitride semiconductor light-emitting element 100, P-type interlayer 110 is an AlGaN layer. In other words, the composition of P-type interlayer 110 is AlₓGa₁₋ₓN (0 < x < 1). The average Al composition ratio of P-type interlayer 110 may be higher than 3%.

As stated above, since an AlGaN layer that has an average Al composition ratio of at least 3% is used as P-type interlayer 110, it is possible to increase average band gap energy to the extent that it is possible to sufficiently reduce absorption of light in the ultraviolet range.

Furthermore, in nitride semiconductor light-emitting element 100, the average Al composition ratio of each of N-type cladding layer 104, N-side optical guide layer 706, P-type interlayer 110, P-side optical guide layer 111, and P-type cladding layer 112 may be less than 10%.

According to this configuration, it is possible to reduce stress in entire nitride semiconductor light-emitting element 100 and internal stress caused by a lattice mismatch. Concomitantly, in the process of manufacturing nitride semiconductor light-emitting element 100, it is possible to reduce breaks and cracks in a wafer on which semiconductor structure 100S is provided. In addition, it is possible to reduce defects produced inside nitride semiconductor light-emitting element 100. Accordingly, it is possible to improve the yield of nitride semiconductor light-emitting element 100.

Moreover, nitride semiconductor light-emitting element 100 may include ridge 11R that extends in a propagation direction of light (i.e., a direction parallel to the Y-axis direction in each figure).

According to this configuration, it is possible to confine a current supplied to nitride semiconductor light-emitting element 100 in ridge 11R. Additionally, it is possible to provide an optical waveguide along ridge 11R.

Furthermore, in nitride semiconductor light-emitting element 100, a lateral face of ridge 11R may be inclined relative to principal face 101a of substrate 101. An advantageous effect achieved by such a configuration of ridge 11R is described with reference to FIG. 6 and FIG. 7. FIG. 6 is a schematic cross-sectional diagram illustrating the shape of lateral faces 11Rs of ridge 11R according to the present embodiment. FIG. 6 shows the outline of ridge 11R. FIG. 7 is a graph showing a relation between transverse-modal order of laser light and optical waveguide loss in a nitride semiconductor light-emitting element. FIG. 7 shows the results of simulating optical waveguide loss in the nitride semiconductor light-emitting element that has substantially the same waveguide structure as nitride semiconductor light-emitting element 100 according to the present embodiment. In addition, FIG. 7 shows optical waveguide loss when inclination angle θᵣ of lateral face 11Rs of ridge 11R is 50 degrees, 60 degrees, 70 degrees, 80 degrees, and 90 degrees. It should be noted that since no substantial difference in optical waveguide loss is found between when inclination angle θᵣ is 80 degrees and when inclination angle θᵣ is 90 degrees, FIG. 7 shows optical waveguide loss collectively when inclination angle θᵣ is between 80 degrees to 90 degrees.

As shown in FIG. 6, inclination angle θᵣ of lateral face 11Rs (an end face of ridge 11R in the X-axis direction) of ridge 11R is defined relative to principal face 101a of substrate 101. It should be noted that an X-Y plane shown in FIG. 6 is a plane parallel to principal face 101a of substrate 101.

As shown in FIG. 7, the optical waveguide loss as a whole tends to increase with an increase in order, and is the same value regardless of inclination angle θᵣ in a lower-order mode (e.g., a zero-order mode). Hereinafter, tendencies relative to inclination angle θᵣ are indicated. When inclination angle θᵣ is at least 80 degrees, the optical waveguide loss does not change significantly relative to modal order. Optical waveguide loss of higher-order mode light (e.g., twelfth-order mode light) increases more when inclination angle θᵣ is less than 80 degrees than when inclination angle θᵣ is at least 80 degrees. In particular, when inclination angle θᵣ is 70 degrees, the optical waveguide loss of the twelfth-order mode light is the greatest, compared to cases of the other angles. On the other hand, when inclination angle θᵣ is 50 degrees, loss of middle-order mode light such as fourth mode light or seventh mode light increases, and the inclination angle indicates greater optical waveguide loss than the other angles. As with nitride semiconductor light-emitting element 100 according to the present embodiment, as in at least one of a case in which the average Al composition ratio of N-type cladding layer 104 is small (e.g., less than 10%) or a case in which the thickness of N-type cladding layer 104 is relatively small, a substrate mode in which light propagates through substrate 101 is likely to occur. For this reason, in nitride semiconductor light-emitting element 100 according to the present embodiment, the optical waveguide loss as described above becomes prominent.

Here, the higher-order mode light such as the twelfth-order mode light causes a portion that bends non-linearly (i.e., a kink) to occur in a graph showing a current-light (IL) curve of nitride semiconductor light-emitting element 100.

As shown in FIG. 7, for example, by causing inclination angle θᵣ to be at least 60 degrees and less than 80 degrees, it is possible to increase the optical waveguide loss of the higher-order light and reduce the optical waveguide loss of the middle-order mode light. In other words, it is possible to reduce the occurrence of the kink in the current-light curve by decreasing an abundance ratio of the higher-order mode light while reducing the optical waveguide loss of the lower-order mode light and the middle-order mode light. Moreover, by decreasing the abundance ratio of the higher-order mode light, it is possible to reduce the occurrence of a substrate mode, and reduce anti-waveguide mode light that leaks from lateral face 11Rs of ridge 11R to the outside of ridge 11R. Furthermore, by decreasing the abundance ratio of the higher-order mode light, it is also possible to decrease an angle of horizontal divergence (an angle of divergence within the X-Y plane) of output light of nitride semiconductor light-emitting element 100.

Moreover, inclination angle θᵣ may be at least 60 degrees and at most 75 degrees. According to this configuration, it is possible to further decrease the abundance ratio of the higher-order mode light.

It should be noted that the following method makes it possible to achieve ridge 11R having such inclination angle θᵣ.

In general, it is possible to etch a nitride semiconductor with chlorine radicals or ions. Specifically, by using an inductively super magnetron (ISM) method or an inductively coupled plasma (ICP) method, gas containing chlorine is converted into plasma, and the nitride semiconductor is irradiated with the plasma. Etching with chlorine ions contained in plasma shows a high degree of anisotropy. For this reason, the etching with the chlorine ions enables etching that has a high verticality. In contrast, etching with chlorine radicals shows a high degree of isotropy. It is possible to control an abundance ratio between the chlorine ions and the chlorine radicals or kinetic energy of the chlorine ions by changing pressure or a voltage to be applied in the above-described method. For this reason, it is possible to control a balance between anisotropic etching and isotropic etching and obtain desired inclination angle θᵣ.

Here, nitride semiconductor light-emitting element 100 according to the present embodiment has the following advantageous effects additionally. Since an optical confinement function works even in a place closer to active layer 107 than to P-type cladding layer 112 when P-type interlayer 110 that has a lower refractive index than P-side optical guide layer 111 is disposed between electron blocking layer 109 and P-side optical guide layer 111, the center of a light distribution shifts to the N side (i.e., in a direction toward N-type cladding layer 104), and effective refractive index difference ΔN decreases. Such a shift of the light distribution to the N side causes a decrease in effective gain, and brings about an increase in threshold current as a consequence. In addition, since a higher-order mode in the waveguide becomes unstable with the decrease in effective refractive index difference ΔN, a kink is caused.

Accordingly, in order to reduce the influence of P-type interlayer 110 on the light distribution, when the Al composition ratio of P-type cladding layer 112 is high, the thickness of P-type interlayer 110 may be decreased, and when the Al composition ratio of P-type cladding layer 112 is low, the thickness of P-type interlayer 110 may be increased. As with the present embodiment, in the case where the Al composition ratio of P-side optical guide layer 111 is 0.03 (i.e., 3%) and the Al composition ratio of P-type cladding layer 112 is 0.065 (i.e., 6.5%), when the Al composition ratio of P-type interlayer 110 is at least 0.050 and at most 0.080 (i.e., at least 5.0% and at most 8.0%), the thickness of P-type interlayer 110 may be at least 5 nm and at most 20 nm, and when the Al composition ratio of P-type interlayer 110 is at least 0.030 and at most 0.050 (i.e., at least 3.0% and at most 5.0%), the thickness of P-type interlayer 110 may be at least 20 nm and at most 40 nm.

In particular, when the Al composition ratio of P-type interlayer 110 is higher than the Al composition ratio of P-type cladding layer 112 (i.e., when the Al composition ratio of P-type interlayer 110 is at least 0.065 and at most 0.080), the thickness of P-type interlayer 110 may be at least 5 nm and at most 10 nm.

### [Embodiment 2]

A nitride semiconductor light-emitting element according to Embodiment 2 is described below. The nitride semiconductor light-emitting element according to the present embodiment differs from nitride semiconductor light-emitting element 100 according to Embodiment 1 in the configuration of a P-type interlayer, and is identical in the other configurations to nitride semiconductor light-emitting element 100. With regard to the nitride semiconductor light-emitting element according to the present embodiment, the following description focuses mainly on differences from nitride semiconductor light-emitting element 100 according to Embodiment 1 with reference to FIG. 8.

FIG. 8 is a schematic graph showing a band gap energy distribution and an impurity concentration distribution in a stacking direction, in the nitride semiconductor light-emitting element according to the present embodiment. As shown in FIG. 8, the nitride semiconductor light-emitting element according to the present embodiment includes P-type interlayer 210.

P-type interlayer 210 differs from P-type interlayer 110 according to Embodiment 1 in that the average band gap energy of P-type interlayer 210 is smaller than the average band gap energy of P-type cladding layer 112. In the present embodiment, P-type interlayer 210 is a P-type Al_{0.05}Ga_{0.95}N layer that is doped with Mg at an average concentration of 1.0 × 10¹⁹ cm⁻³ and has a thickness of 20 nm.

The nitride semiconductor light-emitting element according to the present embodiment including the configuration thus described achieves the same advantageous effects as nitride semiconductor light-emitting 100 according to Embodiment 1.

Moreover, in the nitride semiconductor light-emitting element according to the present embodiment, the average band gap energy of P-type interlayer 210 is smaller than the average band gap energy of P-type cladding layer 112.

With this configuration, it is possible to cause the average refractive index of P-type interlayer 210 to be higher than the average refractive index of P-type cladding layer 112. Accordingly, in the present embodiment, P-type interlayer 210 is also capable of serving as an optical guide layer. For this reason, it is possible to reduce the optical loss in the nitride semiconductor light-emitting element without decreasing the function of confining light in active layer 107.

Furthermore, as with the present embodiment, it is possible to reduce a decline in the function of confining light in active layer 107 with an increase in thickness of P-type interlayer 210, by increasing the average refractive index of P-type interlayer 210. Accordingly, even when a region that has a high impurity concentration is large, increasing the thickness of P-type interlayer 210 makes it possible to reduce the optical loss while reducing a decline in the optical confinement function.

### [Embodiment 3]

A nitride semiconductor light-emitting element according to Embodiment 3 is described below. The nitride semiconductor light-emitting element according to the present embodiment differs from nitride semiconductor light-emitting element 100 according to Embodiment 1 in a relative position between the position of a lower end portion of a ridge and P-type interlayer 110, and is identical in the other configurations to nitride semiconductor light-emitting element 100. With regard to the nitride semiconductor light-emitting element according to the present embodiment, the following description focuses mainly on differences from nitride semiconductor light-emitting element 100 according to Embodiment 1 with reference to FIG. 9.

FIG. 9 is a schematic cross-sectional view of the overall configuration of nitride semiconductor light-emitting element 300 according to the present embodiment. FIG. 9 shows a cross section of nitride semiconductor light-emitting element 300 in the same position as FIG. 2.

As shown in FIG. 9, as with nitride semiconductor light-emitting element 100 according to Embodiment 1, nitride semiconductor light-emitting element 300 according to the present embodiment includes substrate 101, semiconductor structure 100S, current blocking layer 120, P-side electrode 131, adhesion layer 132, pad electrode 133, and N-side electrode 140.

In the present embodiment, ridge 21R is provided in contact layer 113, P-type cladding layer 112, P-side optical guide layer 111, and P-type interlayer 110. In addition, two trenches 21T that are disposed along ridge 21R and extend in the Y-axis direction are provided in contact layer 113, P-type cladding layer 112, P-side optical guide layer 111, and P-type interlayer 110. As stated above, in nitride semiconductor light-emitting element 300 according to the present embodiment, a lower end portion of ridge 21R is located in P-type interlayer 110. In other words, at least a portion of P-type interlayer 110 is disposed in ridge 21R. In the present embodiment, distance dc between the lower end portion of ridge 21R and electron blocking layer 109 is at least 0 nm and less than 20 nm.

Nitride semiconductor light-emitting element 300 according to the present embodiment including the configuration thus described achieves the same advantageous effects as nitride semiconductor light-emitting 100 according to Embodiment 1.

Moreover, in the present embodiment, at least the portion of P-type interlayer 110 is disposed in ridge 21R. With this configuration, P-side optical guide layer 111 located above P-type interlayer 110 is disposed in ridge 21R. For this reason, since ridge 21R is present and the refractive index of current blocking layer 120 located on the side of ridge 21R is lower than the refractive index of ridge 21R, it is possible to improve an optical confinement function in a lateral direction (the X-axis direction in each figure). Accordingly, it is possible to achieve stable multimode oscillation in nitride semiconductor light-emitting element 300.

Furthermore, in the present embodiment, a surface state is formed by dangling bonds (unshared electrons) on the surface of P-type interlayer 110 that is equivalent to the bottom faces and lateral faces of trenches 21T provided by etching. This decreases the band gap of a region of P-type interlayer 110 adjacent to the bottom faces and lateral faces of trenches 21T. Additionally, an absorption range in an absorption coefficient spectrum undergoes a long-wavelength shift by doping P-type interlayer 110 with Mg. For absorption loss caused by these factors, as with the present embodiment, by using P-type interlayer 110 having an Al composition ratio higher than the Al composition ratio of P-side optical guide layer 111, it is possible to include P-type interlayer 110 that has higher average band gap energy than P-side optical guide layer 111. Accordingly, even when the lower end portion of ridge 21R is disposed in P-type interlayer 110, it is possible to reduce the absorption loss in the region of P-type interlayer 110 adjacent to trenches 21T.

### [Embodiment 4]

A nitride semiconductor light-emitting element according to Embodiment 4 is described below. The nitride semiconductor light-emitting element according to the present embodiment differs from nitride semiconductor light-emitting element 100 according to Embodiment 1 in the configuration of a P-type interlayer, and is identical in the other configurations to nitride semiconductor light-emitting element 100. With regard to the nitride semiconductor light-emitting element according to the present embodiment, the following description focuses mainly on differences from nitride semiconductor light-emitting element 100 according to Embodiment 1 with reference to FIG. 10.

FIG. 10 is a schematic graph showing a band gap energy distribution and an impurity concentration distribution in a stacking direction, in the nitride semiconductor light-emitting element according to the present embodiment. As shown in FIG. 10, the nitride semiconductor light-emitting element according to the present embodiment includes P-type interlayer 410.

P-type interlayer 410 includes: first P-type interlayer 410a; and second P-type interlayer 410b that is disposed above first P-type interlayer 410a and has smaller average band gap energy than first P-type interlayer 410a. The average Al composition ratio of first P-type interlayer 410a is higher than the average Al composition ratio of second P-type interlayer 410b.

In the present embodiment, the average band gap energy of first P-type interlayer 410a is higher than the average band gap energy of P-type cladding layer 112, and the average band gap energy of P-type interlayer 410 is smaller than the average band gap energy of P-type cladding layer 112. In addition, the average impurity concentration (average Mg concentration) of first P-type interlayer 410a is higher than the average impurity concentration of second P-type interlayer 410b.

In the present embodiment, first P-type interlayer 410a is a P-type Al_{0.08}Ga_{0.92}N layer that is doped with Mg at an average concentration of 1.3 × 10¹⁹ cm⁻³ and has a thickness of 5 nm, and second P-type interlayer 410b is a P-type Al_{0.05}Ga_{0.95}N layer that is doped with Mg at an average concentration of 9.0 × 10¹⁸ cm⁻³ and has a thickness of 15 nm.

The nitride semiconductor light-emitting element according to the present embodiment including the configuration thus described achieves the same advantageous effects as nitride semiconductor light-emitting 100 according to Embodiment 1.

Moreover, in the present embodiment, P-type interlayer 410 includes: first P-type interlayer 410a; and second P-type interlayer 410b that is disposed above first P-type interlayer 410a and has smaller average band gap energy than first P-type interlayer 410a.

Here, in P-type interlayer 410, the impurity concentration is likely to increase with decreasing distance from electron blocking layer 109 due to the above-described influence of the residual impurities. In an AlGaN layer such as P-type interlayer 410, optical absorption increases with an increase in impurity concentration. In the present embodiment, by including first P-type interlayer 410a having high average band gap energy in a region that is close to electron blocking layer 109 and has a high impurity concentration, it is possible to further reduce the optical loss in P-type interlayer 410.

Furthermore, in the present embodiment, the average band gap energy of first P-type interlayer 410a may be higher than the average band gap energy of P-type cladding layer 112, and the average band gap energy of P-type interlayer 410 may be smaller than the average band gap energy of P-type cladding layer 112.

As stated above, by increasing the average band gap energy of first P-type interlayer 410a located in a portion of P-type interlayer 410 in which especially an impurity concentration is likely to increase and is in the vicinity of electron blocking layer 109, it is possible to reduce the optical loss in first P-type interlayer 410a. In addition, by causing the average band gap energy of entire P-type interlayer 410 to be smaller than the average band gap energy of P-type cladding layer 112, it is possible to cause a portion of P-type interlayer 410 to serve as an optical guide layer in the same manner as Embodiment 2. Additionally, by decreasing the band gap energy of P-type interlayer 410, it is possible to decrease the average Al composition ratio of entire P-type interlayer 410. Since this makes it possible to increase the proportion of impurities that serve as acceptors to impurities with which P-type interlayer 410 is doped, it is possible to reduce electrical resistance in P-type interlayer 410.

It should be noted that although P-type interlayer 410 includes two layers of first P-type interlayer 410a and second P-type interlayer 410b in the present embodiment, P-type interlayer 410 may include three or more layers. For example, P-type interlayer 410 may further include a third P-type interlayer that is disposed above second P-type interlayer 410b and has smaller average band gap energy than second P-type interlayer 410b.

### [Embodiment 5]

A nitride semiconductor light-emitting element according to Embodiment 5 is described below. The nitride semiconductor light-emitting element according to the present embodiment differs from nitride semiconductor light-emitting element 100 according to Embodiment 1 in the configuration of a P-type interlayer, and is identical in the other configurations to nitride semiconductor light-emitting element 100. With regard to the nitride semiconductor light-emitting element according to the present embodiment, the following description focuses mainly on differences from nitride semiconductor light-emitting element 100 according to Embodiment 1 with reference to FIG. 11.

FIG. 11 is a schematic graph showing a band gap energy distribution and an impurity concentration distribution in a stacking direction, in the nitride semiconductor light-emitting element according to the present embodiment. As shown in FIG. 11, the nitride semiconductor light-emitting element according to the present embodiment includes P-type interlayer 510.

P-type interlayer 510 includes a P-type gradient region in which an Al composition ratio decreases with increasing distance from electron blocking layer 109. In the present embodiment, entire P-type interlayer 510 is the P-type gradient region. The average band gap energy of P-type interlayer 510 is smaller than the average band gap energy of P-type cladding layer 112.

Moreover, P-type interlayer 510 includes an impurity concentration gradient region in which an impurity concentration decreases with increasing distance from electron blocking layer 109. In the present embodiment, entire P-type interlayer 510 is the impurity concentration gradient region.

In the present embodiment, P-type interlayer 510 is a P-type AlGaN layer that is doped with Mg at an average concentration of 1.0 × 10¹⁹ cm⁻³ and has a thickness of 20 nm. A composition of P-type interlayer 510 in an interface with electron blocking layer 109 is Al_{0.08}Ga_{0.02}N, and a composition of P-type interlayer 510 in an interface with P-side optical guide layer 111 is Al_{0.05}Ga_{0.95}N. The Al composition ratio of P-type interlayer 510 continuously decreases with increasing distance from electron blocking layer 109. In addition, the impurity concentration of P-type interlayer 510 continuously decreases from 1.5 × 10¹⁹ cm⁻³ to 2.0 × 10¹⁸ cm⁻³.

The nitride semiconductor light-emitting element according to the present embodiment including the configuration thus described achieves the same advantageous effects as nitride semiconductor light-emitting 100 according to Embodiment 1.

Furthermore, in the present embodiment, P-type interlayer 510 includes a P-type gradient region in which an Al composition ratio decreases with increasing distance from electron blocking layer 109.

Here, in P-type interlayer 510, the impurity concentration is likely to decrease with increasing distance from electron blocking layer 109 due to the above-described influence of the residual impurities. Additionally, in an AlGaN layer such as P-type interlayer 510, optical absorption increases with an increase in impurity concentration. In the present embodiment, by including the P-type gradient region in which the Al composition ratio decreases with increasing distance from electron blocking layer 109, it is possible to decrease the band gap energy with increasing distance from electron blocking layer 109. For this reason, it is possible to decrease the Al composition ratio while reducing the optical loss in P-type interlayer 510.

Moreover, in the present embodiment, the average band gap energy of P-type interlayer 510 may be smaller than the average band gap energy of P-type cladding layer 112.

With this configuration, it is possible to cause a portion of P-type interlayer 510 to serve as an optical guide layer in the same manner as Embodiment 2. Additionally, by decreasing the band gap energy of P-type interlayer 510, it is possible to decrease the average Al composition ratio of entire P-type interlayer 510. Since this makes it possible to increase the proportion of impurities that serve as acceptors to impurities with which P-type interlayer 510 is doped, it is possible to reduce electrical resistance in P-type interlayer 510.

### [Embodiment 6]

A nitride semiconductor light-emitting element according to Embodiment 6 is described below. The nitride semiconductor light-emitting element according to the present embodiment differs from nitride semiconductor light-emitting element 100 according to Embodiment 1 in the configuration of a P-type interlayer, and is identical in the other configurations to nitride semiconductor light-emitting element 100. With regard to the nitride semiconductor light-emitting element according to the present embodiment, the following description focuses mainly on differences from nitride semiconductor light-emitting element 100 according to Embodiment 1 with reference to FIG. 12.

FIG. 12 is a schematic graph showing a band gap energy distribution and an impurity concentration distribution in a stacking direction, in the nitride semiconductor light-emitting element according to the present embodiment. As shown in FIG. 12, the nitride semiconductor light-emitting element according to the present embodiment includes P-type interlayer 610.

P-type interlayer 610 includes: first P-type interlayer 610a that has smaller average band gap energy than P-type cladding layer 112; and second P-type interlayer 610b that is disposed above first P-type interlayer 610a and has higher average band gap energy than first P-type interlayer 610a. In the present embodiment, second P-type interlayer 610b has smaller average band gap energy than P-type cladding layer 112. The average Al composition ratio of first P-type interlayer 610a is lower than the average Al composition ratio of second P-type interlayer 610b.

In addition, the average impurity concentration (average Mg concentration) of first P-type interlayer 610a is lower than the average impurity concentration of second P-type interlayer 610b.

In the present embodiment, first P-type interlayer 610a is a P-type Al_{0.04}Ga_{0.96}N layer that is doped with Mg at an average concentration of 5.0 × 10¹⁸ cm⁻³ and has a thickness of 10 nm, and second P-type interlayer 610b is a P-type Al_{0.05}Ga_{0.95}N layer that is doped with Mg at an average concentration of 1.0 × 10¹⁹ cm⁻³ and has a thickness of 15 nm.

Since a Mg concentration in a region of P-type interlayer 610 close to active layer 107, that is, a region that has a high light intensity, is low, the effect of reducing optical loss is greater in the nitride semiconductor light-emitting element according to the present embodiment including the configuration thus described than in nitride semiconductor light-emitting element 100 according to Embodiment 1.

Moreover, in the present embodiment, P-type interlayer 610 includes: first P-type interlayer 610a that has smaller average band gap energy than P-type cladding layer 112; and second P-type interlayer 610b that is disposed above first P-type interlayer 610a and has higher average band gap energy than first P-type interlayer 610a.

As stated above, an impurity concentration in a layer stacked on electron blocking layer 109 is likely to increase due to the influence of the residual impurities. The influence may occur when the layer has a thickness of at least approximately 80 nm and at most approximately 100 nm. It is possible to reduce optical loss by disposing P-type interlayer 610 in a large portion of such a region in which the impurity concentration is likely to increase. However, when P-type interlayer 610 has a high refractive index and a great thickness, a decline in the function of confining light in active layer 107 may become prominent.

In the present embodiment, the average refractive index of first P-type interlayer 610a is caused to be higher than the average refractive index of P-type cladding layer 112 by causing the average band gap energy of first P-type interlayer 610a to be smaller than the average band gap energy of P-type cladding layer 112. For this reason, first P-type interlayer 610a that serves as an optical guide layer is disposed in the region of P-type interlayer 610 close to active layer 107. Accordingly, it is possible to reduce the decline in the function of confining light in active layer 107 in the nitride semiconductor light-emitting element according to the present embodiment.

Furthermore, the average impurity concentration of first P-type interlayer 610a may be lower than the average impurity concentration of second P-type interlayer 610b. Since this makes it possible to reduce shift of an optical absorption edge to the long-wavelength side due to impurities in first P-type interlayer 610a, it is possible to reduce optical loss in first P-type interlayer 610a.

Moreover, the thickness of first P-type interlayer 610a may be less than 15 nm. For this reason, it is possible to reduce the optical loss in first P-type interlayer 610a.

It should be noted that although P-type interlayer 610 includes two layers of first P-type interlayer 610a and second P-type interlayer 610b in the present embodiment, P-type interlayer 610 may include three or more layers. For example, P-type interlayer 610 may further include a third P-type interlayer that is disposed above second P-type interlayer 610b and has smaller average band gap energy than second P-type interlayer 610b.

### [Embodiment 7]

A nitride semiconductor light-emitting element according to Embodiment 7 is described below. The nitride semiconductor light-emitting element according to the present embodiment differs from nitride semiconductor light-emitting element 100 according to Embodiment 1 in including an N-type interlayer, and is identical in the other configurations to nitride semiconductor light-emitting element 100. With regard to the nitride semiconductor light-emitting element according to the present embodiment, the following description focuses mainly on differences from nitride semiconductor light-emitting element 100 according to Embodiment 1 with reference to FIG. 13 and FIG. 14.

FIG. 13 is a schematic cross-sectional view of the overall configuration of nitride semiconductor light-emitting element 700 according to the present embodiment. FIG. 13 shows a cross section of nitride semiconductor light-emitting element 700 in the same position as FIG. 2. FIG. 14 is a schematic graph showing a band gap energy distribution and an impurity concentration distribution in a stacking direction, in nitride semiconductor light-emitting element 700 according to the present embodiment.

As shown in FIG. 13, nitride semiconductor light-emitting element 700 according to the present embodiment includes substrate 101, semiconductor structure 700S, current blocking layer 120, P-side electrode 131, adhesion layer 132, pad electrode 133, and N-side electrode 140.

Semiconductor structure 700S includes foundation layer 102, buffer layer 103, N-type cladding layer 104, N-type interlayer 705, N-side optical guide layer 706, active layer 107, electron blocking layer 109, P-type interlayer 110, P-side optical guide layer 111, P-type cladding layer 112, and contact layer 113.

N-type interlayer 705 is a nitride semiconductor layer that is disposed above N-type cladding layer 104 and includes Al. The average band gap energy of N-type interlayer 705 is higher than the average band gap energy of N-side optical guide layer 706, and is smaller than the average band gap energy of N-type cladding layer 104. The average Al composition ratio of N-type interlayer 705 may be less than 10%. The average impurity concentration of N-type interlayer 705 is lower than or equal to the average impurity concentration of N-type cladding layer 104, and is higher than the average impurity concentration of N-side optical guide layer 706. In the present embodiment, N-type interlayer 705 is an N-type Al_{0.05}Ga_{0.95}N layer that is doped with Si at an average concentration of 1.0 × 10¹⁸ cm⁻³ and has a thickness of 20 nm.

N-side optical guide layer 706 is a nitride semiconductor layer that is disposed above N-type interlayer 705 and includes Al. N-side optical guide layer 706 has a higher average refractive index and smaller average band gap energy than N-type cladding layer 104 and N-type interlayer 705. In the present embodiment, N-side optical guide layer 706 is an undoped Al_{0.03}Ga_{0.97}N layer that has a thickness of 187 nm. The thickness of N-type interlayer 705 is at least 20 nm.

Advantageous effects achieved by nitride semiconductor light-emitting element 700 according to the present embodiment are described below.

When N-side optical guide layer 706 that is an undoped AlGaN layer is directly stacked on N-type cladding layer 104 that is an AlGaN layer that is doped with Si as N-type impurities, although smaller than the influence of P-type impurity residues, the influence of impurity residues may be caused. For this reason, an impurity concentration in a region of N-side optical guide layer 706 especially in the vicinity of N-cladding layer 104 may be higher than a designed value. Additionally, as with the P-type AlGaN layer, an optical absorption edge may shift to the long-wavelength side according to an impurity concentration in an N-type AlGaN layer. For this reason, the optical loss in N-side optical guide layer 706 may increase.

Since nitride semiconductor light-emitting element 700 according to the present embodiment includes, in a region that is on N-type cladding layer 104 and in which an impurity concentration is likely to be high, N-type interlayer 705 that has the higher average band gap energy than N-side optical guide layer 706, it is possible to reduce the optical absorption in the same manner as P-type interlayer 110. As stated above, nitride semiconductor light-emitting element 700 according to the present embodiment makes it possible to reduce the optical loss while decreasing the Al composition ratio of each of the layers such as N-side optical guide layer 706 and N-type cladding layer 104.

Moreover, in nitride semiconductor light-emitting element 700, the thickness of N-type interlayer 705 may be at least 20 nm.

In a region that is spaced at least 20 nm from N-type cladding layer 104 in the upward direction, the influence of residual impurities is reduced. For example, in the region spaced at least 20 nm from N-type cladding layer 104 in the upward direction, it is possible to decrease an impurity concentration to less than or equal to half of an impurity concentration in an upper interface of N-type cladding layer 104. Accordingly, since the thickness of N-type interlayer 705 is at least 20 nm, it is possible to sufficiently reduce the optical loss caused by the residual impurities.

Furthermore, in nitride semiconductor light-emitting element 700, N-type interlayer 705 is an AlGaN layer. In other words, the composition of N-type interlayer 705 is Al_{y}Ga_{1-y}N (0 < y < 1). The average Al composition ratio of N-type interlayer 705 may be higher than 3%.

As stated above, by using, as N-type interlayer 705, an AlGaN layer that has an average Al composition ratio of at least 3%, it is possible to increase average band gap energy to the extent that it is possible to sufficiently reduce absorption of light in the ultraviolet range.

Moreover, in nitride semiconductor light-emitting element 700, the average Al composition ratio of each of N-type cladding layer 104, N-side optical guide layer 706, N-type interlayer 705, P-side optical guide layer 111, and P-type cladding layer 112 may be less than 10%.

According to this configuration, it is possible to reduce stress in entire nitride semiconductor light-emitting element 700 and internal stress caused by a lattice mismatch. Concomitantly, in a process of manufacturing nitride semiconductor light-emitting element 700, it is possible to reduce breaks and cracks in a wafer on which semiconductor structure 700S is provided. In addition, it is possible to reduce defects produced inside nitride semiconductor light-emitting element 700. Accordingly, it is possible to improve the yield of nitride semiconductor light-emitting element 700.

### [Embodiment 8]

A nitride semiconductor light-emitting element according to Embodiment 8 is described below. The nitride semiconductor light-emitting element according to the present embodiment differs from nitride semiconductor light-emitting element 700 according to Embodiment 7 in the configuration of an N-type interlayer, and is identical in the other configurations to nitride semiconductor light-emitting element 700. With regard to the nitride semiconductor light-emitting element according to the present embodiment, the following description focuses mainly on differences from nitride semiconductor light-emitting element 700 according to Embodiment 7 with reference to FIG. 15.

FIG. 15 is a schematic graph showing a band gap energy distribution and an impurity concentration distribution in a stacking direction, in the nitride semiconductor light-emitting element according to the present embodiment. As shown in FIG. 15, the nitride semiconductor light-emitting element according to the present embodiment includes N-type interlayer 805.

N-type interlayer 805 includes: first N-type interlayer 805a; and second N-type interlayer 805b that is disposed above first N-type interlayer 805a and has smaller average band gap energy than first N-type interlayer 805a. The average Al composition ratio of first N-type interlayer 805a is higher than the average Al composition ratio of second N-type interlayer 805b.

In the present embodiment, the average impurity concentration (average Si concentration) of first N-type interlayer 805a is higher than the average impurity concentration of second N-type interlayer 805b.

In the present embodiment, first N-type interlayer 805a is an N-type Al_{0.06}Ga_{0.94}N layer that is doped with Si at an average concentration of 1.0 × 10¹⁸ cm⁻³ and has a thickness of 10 nm, and second N-type interlayer 805b is an N-type Al_{0.05}Ga_{0.95}N layer that is doped with Si at an average concentration of 8.0 × 10¹⁷ cm⁻³ and has a thickness of 10 nm.

The nitride semiconductor light-emitting element according to the present embodiment including the configuration thus described achieves the same advantageous effects as nitride semiconductor light-emitting 700 according to Embodiment 7.

Moreover, in the present embodiment, N-type interlayer 805 includes: first N-type interlayer 805a; and second N-type interlayer 805b that is disposed above first N-type interlayer 805a and has smaller average band gap energy than first N-type interlayer 805a.

Here, in N-type interlayer 805, the impurity concentration is likely to increase with decreasing distance from N-type cladding layer 104 due to the above-described influence of the residual impurities. In an AlGaN layer such as N-type interlayer 805, optical absorption increases with an increase in impurity concentration. In the present embodiment, by including first N-type interlayer 805a having high average band gap energy in a region that is close to N-type cladding layer 104 and has a high impurity concentration, it is possible to further reduce the optical loss in N-type interlayer 805.

It should be noted that although N-type interlayer 805 includes two layers of first N-type interlayer 805a and second N-type interlayer 805b in the present embodiment, N-type interlayer 805 may include three or more layers. For example, N-type interlayer 805 may further include a third N-type interlayer that is disposed above second N-type interlayer 805b and has smaller average band gap energy than second N-type interlayer 805b.

### [Embodiment 9]

A nitride semiconductor light-emitting element according to Embodiment 9 is described below. The nitride semiconductor light-emitting element according to the present embodiment differs from nitride semiconductor light-emitting element 700 according to Embodiment 7 in the configuration of an N-type interlayer, and is identical in the other configurations to nitride semiconductor light-emitting element 700. With regard to the nitride semiconductor light-emitting element according to the present embodiment, the following description focuses mainly on differences from nitride semiconductor light-emitting element 700 according to Embodiment 7 with reference to FIG. 16.

FIG. 16 is a schematic graph showing a band gap energy distribution and an impurity concentration distribution in a stacking direction, in the nitride semiconductor light-emitting element according to the present embodiment. As shown in FIG. 16, the nitride semiconductor light-emitting element according to the present embodiment includes N-type interlayer 905.

N-type interlayer 905 includes an N-type gradient region in which an Al composition ratio decreases with increasing distance from N-type cladding layer 104. In the present embodiment, entire N-type interlayer 905 is the N-type gradient region. The average band gap energy of N-type interlayer 905 is smaller than the average band gap energy of N-type cladding layer 104.

In addition, N-type interlayer 905 includes an impurity concentration gradient region in which an impurity concentration decreases with increasing distance from N-type cladding layer 104. In the present embodiment, entire N-type interlayer 905 is the impurity concentration gradient region.

In the present embodiment, N-type interlayer 905 is an N-type AlGaN layer that is doped with Si at an average concentration of 8.0 × 10¹⁷ cm⁻³ and has a thickness of 20 nm. A composition of N-type interlayer 905 in an interface with N-type cladding layer 104 is Al_{0.065}Ga_{0.935}N, and a composition of N-type interlayer 905 in an interface with N-side optical guide layer 706 is Al_{0.05}Ga_{0.95}N. The Al composition ratio of N-type interlayer 905 continuously decreases with increasing distance from N-type cladding layer 104. Additionally, the impurity concentration of N-type interlayer 905 continuously decreases with increasing distance from N-type cladding layer 104.

The nitride semiconductor light-emitting element according to the present embodiment including the configuration thus described achieves the same advantageous effects as nitride semiconductor light-emitting 700 according to Embodiment 7.

Moreover, in the present embodiment, N-type interlayer 905 includes an N-type gradient region in which an Al composition ratio decreases with increasing distance from N-type cladding layer 104.

Here, in N-type interlayer 905, the impurity concentration is likely to decrease with increasing distance from N-type cladding layer 104 due to the above-described influence of the residual impurities. In addition, in an AlGaN layer such as N-type interlayer 905, optical absorption increases with an increase in impurity concentration. In the present embodiment, by including the N-type gradient region in which the Al composition ratio decreases with increasing distance from N-type cladding layer 104, it is possible to reduce the band gap energy with increasing distance from N-type cladding layer 104. For this reason, it is possible to decrease the Al composition ratio while reducing the optical loss in N-type interlayer 905.

### [Embodiment 10]

A nitride semiconductor light-emitting element according to Embodiment 10 is described below. The nitride semiconductor light-emitting element according to the present embodiment differs from nitride semiconductor light-emitting element 700 according to Embodiment 7 in the configuration of an N-type interlayer, and is identical in the other configurations to nitride semiconductor light-emitting element 700. With regard to the nitride semiconductor light-emitting element according to the present embodiment, the following description focuses mainly on differences from nitride semiconductor light-emitting element 700 according to Embodiment 7 with reference to FIG. 17.

FIG. 17 is a schematic graph showing a band gap energy distribution and an impurity concentration distribution in a stacking direction, in the nitride semiconductor light-emitting element according to the present embodiment. As shown in FIG. 17, the nitride semiconductor light-emitting element according to the present embodiment includes N-type interlayer 1005.

N-type interlayer 1005 includes: first N-type interlayer 1005a that has smaller average band gap energy than N-type cladding layer 104; and second N-type interlayer 1005b that is disposed above first N-type interlayer 1005a and has higher average band gap energy than first N-type interlayer 1005a. In the present embodiment, second N-type interlayer 1005b has smaller average band gap energy than N-type cladding layer 104. The average Al composition ratio of first N-type interlayer 1005a is lower than the average Al composition ratio of second N-type interlayer 1005b.

In addition, the average impurity concentration (average Si concentration) of first N-type interlayer 1005a is lower than the average impurity concentration of second N-type interlayer 1005b.

In the present embodiment, first N-type interlayer 1005a is an N-type Al_{0.05}Ga_{0.95}N layer that is doped with Si at an average concentration of 8.0 × 10¹⁷ cm⁻³ and has a thickness of 10 nm, and second N-type interlayer 1005b is an N-type Al_{0.06}Ga_{0.94}N layer that is doped with Si at an average concentration of 1.0 × 10¹⁸ cm⁻³ and has a thickness of 10 nm.

The nitride semiconductor light-emitting element according to the present embodiment including the configuration thus described achieves the same advantageous effects as nitride semiconductor light-emitting 700 according to Embodiment 7.

Moreover, in the present embodiment, N-type interlayer 1005 includes: first N-type interlayer 1005a that has smaller average band gap energy than N-type cladding layer 104; and second N-type interlayer 1005b that is disposed above first N-type interlayer 1005a and has higher average band gap energy than first N-type interlayer 1005a.

As stated above, an impurity concentration in a layer stacked on N-type cladding layer 104 is likely to increase due to the influence of the residual impurities. The influence may occur when the layer has a thickness of at least approximately 20 nm. It is possible to reduce optical loss by disposing N-type interlayer 1005 in a large portion of such a region in which the impurity concentration is likely to increase. However, when N-type interlayer 1005 has a high refractive index and a great thickness, a decline in the function of confining light in active layer 107 may become prominent.

In the present embodiment, the average refractive index of first N-type interlayer 1005a is caused to be higher than the average refractive index of N-type cladding layer 104 by causing the average band gap energy of first N-type interlayer 1005a to be smaller than the average band gap energy of N-type cladding layer 104. In this way, first N-type interlayer 1005a that serves as an optical guide layer is disposed in N-type interlayer 1005. Accordingly, it is possible to reduce the decline in the function of confining light in active layer 107 in the nitride semiconductor light-emitting element according to the present embodiment.

Furthermore, the average impurity concentration of first N-type interlayer 1005a may be lower than the average impurity concentration of second N-type interlayer 1005b. Since this makes it possible to reduce shift of an optical absorption edge to the long-wavelength side due to the impurities in first N-type interlayer 1005a, it is possible to reduce the optical loss in first N-type interlayer 1005a.

Moreover, the thickness of first N-type interlayer 1005a may be less than 15 nm. For this reason, it is possible to reduce the optical loss in first N-type interlayer 1005a.

It should be noted that although N-type interlayer 1005 includes two layers of first N-type interlayer 1005a and second N-type interlayer 1005b in the present embodiment, N-type interlayer 1005 may include three or more layers. For example, N-type interlayer 1005 may further include a third N-type interlayer that is disposed above second N-type interlayer 1005b and has smaller average band gap energy than second N-type interlayer 1005b.

### [Embodiment 11]

A nitride semiconductor light-emitting element according to Embodiment 11 is described below. The nitride semiconductor light-emitting element according to the present embodiment differs from nitride semiconductor light-emitting element 100 according to Embodiment 1 mainly in a layer configuration between an active layer and an electron blocking layer. With regard to the nitride semiconductor light-emitting element according to the present embodiment, the following description focuses mainly on differences from nitride semiconductor light-emitting element 100 according to Embodiment 1.

### [11-1. Overall Configuration]

The overall configuration of the nitride semiconductor light-emitting element according to the present embodiment is described with reference to FIG. 18 and FIG. 19. FIG. 18 is a schematic cross-sectional view of the overall configuration of nitride semiconductor light-emitting element 1100 according to the present embodiment. FIG. 18 shows a cross section of nitride semiconductor light-emitting element 1100 in the same position as FIG. 2. FIG. 19 is a schematic graph showing a band gap energy distribution and an impurity concentration distribution in a stacking direction, in nitride semiconductor light-emitting element 1100 according to the present embodiment.

As shown in FIG. 18, nitride semiconductor light-emitting element 1100 according to the present embodiment includes substrate 101, semiconductor structure 1100S, current blocking layer 120, P-side electrode 131, adhesion layer 132, pad electrode 133, and N-side electrode 140.

Semiconductor structure 1100S includes foundation layer 102, buffer layer 103, N-type cladding layer 1104, N-side optical guide layer 106, active layer 1107, lower P-side optical guide layer 1111a, lower P-side interlayer 1110a, electron blocking layer 109, P-type interlayer 1110, P-side optical guide layer 111, P-type cladding layer 112, and contact layer 113.

N-type cladding layer 1104 is an N-type nitride semiconductor layer that is disposed above substrate 101 and includes Al. In the present embodiment, N-type cladding layer 1104 is an N-type Al_{0.065}Ga_{0.935}N layer that is doped with Si at an average concentration of 1.0 × 10¹⁸ cm⁻³ and has a thickness of 1500 nm.

Active layer 1107 is a nitride semiconductor layer that is disposed above N-side optical guide layer 106 and includes well layer 107b and barrier layers 107a and 1107c that include Al. Well layer 107b is disposed between barrier layer 107a and barrier layer 1107c.

Barrier layer 1107c is a nitride semiconductor layer that is disposed above N-side optical guide layer 106 and serves as a barrier for a quantum well structure. Barrier layer 1107c is disposed above barrier layer 107a. In the present embodiment, the average band gap energy of barrier layer 1107c is higher than the average band gap energy of well layer 107b. In the present embodiment, barrier layer 1107c is an undoped Al_{0.04}Ga_{0.96}N layer that has a thickness of 10 nm.

Lower P-side optical guide layer 1111a is a nitride semiconductor layer that is disposed between active layer 1107 and electron blocking layer 109 and includes Al. In the present embodiment, lower P-side optical guide layer 1111a is disposed below lower P-side interlayer 1110a. Lower P-side optical guide layer 1111a has a higher average refractive index and smaller average band gap energy than P-type cladding layer 112. Additionally, the average band gap energy of lower P-side optical guide layer 1111a is smaller than the average band gap energy of P-type interlayer 1110, and is smaller than the average band gap energy of barrier layer 1107c that is disposed uppermost out of the plurality of barrier layers in active layer 1107 (i.e., closer to electron blocking layer 109). For this reason, electrical conduction of holes from P-type cladding layer 112 to active layer 1107 beyond electron blocking layer 109 is made easier. Accordingly, it is possible to decrease the operating voltage of nitride semiconductor light-emitting element 1100.

In the present embodiment, the average band gap energy of lower P-side optical guide layer 1111a is smaller than the average band gap energy of lower P-side interlayer 1110a. It is possible to use, for example, an AlGaN layer or an AlGaInN layer as lower P-side optical guide layer 1111a. A detailed configuration example of lower P-side optical guide layer 1111a is described later.

Lower P-side interlayer 1110a is a nitride semiconductor layer that is disposed between lower P-side optical guide layer 1111a and electron blocking layer 109 and includes Al. The average band gap energy of lower P-side interlayer 1110a is higher than the average band gap energy of lower P-side optical guide layer 1111a, and is smaller than the average band gap energy of electron blocking layer 109. Lower P-side interlayer 1110a may be doped with, for example, P-type impurities at an average concentration of at most 2.0 × 10¹⁸ cm⁻³. (Lower P-side interlayer 1110a may be undoped.) Additionally, the average concentration of the P-type impurities in lower P-side interlayer 1110a may be lower than the average concentration of P-type impurities in P-type interlayer 1110. By causing the average concentration of the P-type impurities in lower P-side interlayer 1110a to be at most 2.0 × 10¹⁸ cm⁻³ as above, it is possible to reduce free carrier loss while maintaining electrical conductibility. In the present embodiment, lower P-side interlayer 1110a is an Al_{0.04}Ga_{0.96}N layer that has a thickness of 3 nm, and it is possible to achieve both the reduction of the free carrier loss and the reduction of increase in voltage by causing lower P-side interlayer 1110a to be thinner and undoped.

P-type interlayer 1110 is a P-type nitride semiconductor layer that is disposed above electron blocking layer 109 and includes Al. In the present embodiment, P-type interlayer 1110 is a P-type Al_{0.05}Ga_{0.95}N layer that is doped with Mg at an average concentration of 1.0 × 10¹⁹ cm⁻³ and has a thickness of 56 nm. Moreover, in the present embodiment, a lower end portion of ridge 21R is located in P-type interlayer 1110, and distance dc between the lower end portion of ridge 21R and electron blocking layer 109 is 55 nm. It should be noted that the lower end portion of ridge 21R may be located in P-side optical guide layer 111 above P-type interlayer 1110. For example, distance dc between the lower end portion of ridge 21R and electron blocking layer 109 may be 58 nm.

### [11-2. Operating Characteristics in Configuration Example 1]

Operating characteristics in Configuration Example 1 of nitride semiconductor light-emitting element 1100 according to the present embodiment are described below. In Configuration Example 1 of nitride semiconductor light-emitting element 1100 according to the present embodiment, lower P-side optical guide layer 1111a is an AlGaN layer. Hereinafter, the operating characteristics in Configuration Example 1 of nitride semiconductor light-emitting element 1100 are described with reference to FIG. 20 to FIG. 25. FIG. 20 is a graph showing a relation between optical waveguide loss and the Al composition ratio of lower P-side optical guide layer 1111a in Configuration Example 1 of nitride semiconductor light-emitting element 1100 according to the present embodiment. FIG. 21 is a graph showing a relation between an operating current when power consumption is 0.5 W and the Al composition ratio of lower P-side optical guide layer 1111a in Configuration Example 1 of nitride semiconductor light-emitting element 1100 according to the present embodiment. FIG. 22 is a graph showing a relation between an operating voltage value when power consumption is 0.5 W and the Al composition ratio of lower P-side optical guide layer 1111a in Configuration Example 1 of nitride semiconductor light-emitting element 1100 according to the present embodiment. FIG. 23 is a graph showing a relation between an optical confinement factor and the Al composition ratio of lower P-side optical guide layer 1111a in Configuration Example 1 of nitride semiconductor light-emitting element 1100 according to the present embodiment. FIG. 24 is a graph showing a relation between effective refractive index difference ΔN and the Al composition ratio of lower P-side optical guide layer 1111a in Configuration Example 1 of nitride semiconductor light-emitting element 1100 according to the present embodiment. FIG. 25 is a graph showing a relation between wall-plug efficiency (WPE) when power consumption is 0.5 W and the Al composition ratio of lower P-side optical guide layer 1111a in Configuration Example 1 of nitride semiconductor light-emitting element 1100 according to the present embodiment. FIG. 20 to FIG. 25 each show a relation in a corresponding one of cases in which thickness T1 of lower P-side optical guide layer 1111a is 9 nm, 20 nm, 40 nm, and 60 nm.

It is clear from FIG. 21 to FIG. 25 that, with a decrease in Al composition ratio of lower P-side optical guide layer 1111a that is the AlGaN layer, the operating voltage and the operating current decrease, and the optical confinement factor, effective refractive index difference ΔN, and the WPE increase. The Al composition ratio of lower P-side optical guide layer 1111a may be set to at most 4% based on FIG. 21 to FIG. 25.

It is clear from FIG. 21 to FIG. 23 and FIG. 25 that, with an increase in thickness T1 of lower P-side optical guide layer 1111a, the operating voltage and the operating current decrease, and the optical confinement factor and the WPE increase. Thickness T1 of lower P-side optical guide layer 1111a may be set to at least 9 nm based on FIG. 21 to FIG. 23 and FIG. 25. On the other hand, it is clear from FIG. 24 that when the Al composition ratio of lower P-side optical guide layer 1111a is at least 1%, effective refractive index difference ΔN decreases with an increase in thickness T1, and decreases with an increase in Al composition ratio of lower P-side optical guide layer 1111a. Thickness T1 of lower P-side optical guide layer 1111a may be set to at most 60 nm based on FIG. 24 to achieve effective refractive index difference ΔN of at least approximately 10 × 10⁻³.

Referring to FIG. 20, although the optical waveguide loss hardly depends on the Al composition ratio of lower P-side optical guide layer 1111a, the Al composition ratio of lower P-side optical guide layer 1111a may be higher than 0 to reduce the occurrence of optical absorption loss in lower P-side optical guide layer 1111a. Since this makes it possible to cause the band gap energy of lower P-side optical guide layer 1111a to be higher than the band gap energy of GaN, it is possible to reduce the optical absorption loss in lower P-side optical guide layer 1111a. Additionally, the Al composition ratio of lower P-side optical guide layer 1111a may be at least 1% to further reduce the optical absorption loss in lower P-side optical guide layer 1111a.

In order to increase the refractive index of lower P-side optical guide layer 1111a and improve electrical conductibility, the band gap energy of lower P-side optical guide layer 1111a may be smaller than or equal to the band gap energy of adjacent barrier layer 1107c. For example, in the present embodiment, since barrier layer 1107c is the Al_{0.04}Ga_{0.96}N layer, the Al composition ratio of lower P-side optical guide layer 1111a may be at most 4% to cause the band gap energy of lower P-side optical guide layer 1111a to be smaller than or equal to the band gap energy of barrier layer 1107c.

The Al composition ratio of lower P-side optical guide layer 1111a may be lower than or equal to the Al composition ratio of P-side optical guide layer 111. For example, in the present embodiment, since the Al composition ratio of P-side optical guide layer 111 is 3%, the Al composition ratio of lower P-side optical guide layer 1111a may be at most 3%. Since this makes it possible to cause the refractive index of lower P-side optical guide layer 1111a to be higher than or equal to the refractive index of P-side optical guide layer 111, it is possible to decrease the operating voltage and the operating current and increase the optical confinement factor, effective refractive index difference ΔN, and the WPE.

Lower P-side optical guide layer 1111a may be an undoped AlGaN layer. For this reason, it is possible to reduce optical absorption caused by the above-described increase in impurity concentration.

Working examples of Configuration Example 1 of nitride semiconductor light-emitting element 1100 according to the present embodiment are described with reference to FIG. 26. FIG. 26 is a table showing configurations and characteristics in Working Examples 1 to 4 of nitride semiconductor light-emitting element 1100 according to the present embodiment. FIG. 26 also shows the configuration and characteristics of a nitride semiconductor light-emitting element according to Comparative Example 2. The nitride semiconductor light-emitting element according to Comparative Example 2 differs from nitride semiconductor light-emitting element 1100 according to the present embodiment in not including lower P-side optical guide layer 1111a, and is identical in other respects to nitride semiconductor light-emitting element 1100.

As shown in FIG. 26, in Working Example 1, the Al composition ratio and thickness T1 of lower P-side optical guide layer 1111a are 1.0% and 9.0 nm, respectively; in Working Example 2, the Al composition ratio and thickness T1 of lower P-side optical guide layer 1111a are 2.0% and 20.0 nm, respectively; in Working Example 3, the Al composition ratio and thickness T1 of lower P-side optical guide layer 1111a are 3.0% and 40.0 nm, respectively; and in Working Example 4, the Al composition ratio and thickness T1 of lower P-side optical guide layer 1111a are 1.0% and 60.0 nm, respectively.

As shown in FIG. 26, in Working Examples 1 to 4, an operating voltage and an operating current decrease, and an optical confinement factor and WPE increase, compared to Comparative Example 2 in which lower P-side optical guide layer 1111a is not included. In addition, in Working Examples 1 to 4, it is possible to achieve effective refractive index difference ΔN of at least 10 × 10⁻³. As stated above, in Working Examples 1 to 4, since lower P-side optical guide layer 1111a is included, it is possible to decrease the operating voltage and the operating current and increase the optical confinement factor and the WPE while achieving effective refractive index difference ΔN of at least 10 × 10⁻³.

### [11-3. Operating Characteristics in Configuration Example 2]

Operating characteristics in Configuration Example 2 of nitride semiconductor light-emitting element 1100 according to the present embodiment are described below. In Configuration Example 2 of nitride semiconductor light-emitting element 1100 according to the present embodiment, lower P-side optical guide layer 1111a is an AlGaInN layer. Hereinafter, the operating characteristics in Configuration Example 2 of nitride semiconductor light-emitting element 1100 are described with reference to FIG. 27 to FIG. 32. FIG. 27 is a graph showing a relation between optical waveguide loss and the In composition ratio of lower P-side optical guide layer 1111a in Configuration Example 2 of nitride semiconductor light-emitting element 1100 according to the present embodiment. FIG. 28 is a graph showing a relation between an operating current when power consumption is 0.5 W and the In composition ratio of lower P-side optical guide layer 1111a in Configuration Example 2 of nitride semiconductor light-emitting element 1100 according to the present embodiment. FIG. 29 is a graph showing a relation between an operating voltage value when power consumption is 0.5 W and the In composition ratio of lower P-side optical guide layer 1111a in Configuration Example 2 of nitride semiconductor light-emitting element 1100 according to the present embodiment. FIG. 30 is a graph showing a relation between an optical confinement factor and the In composition ratio of lower P-side optical guide layer 1111a in Configuration Example 2 of nitride semiconductor light-emitting element 1100 according to the present embodiment. FIG. 31 is a graph showing a relation between effective refractive index difference ΔN and the In composition ratio of lower P-side optical guide layer 1111a in Configuration Example 2 of nitride semiconductor light-emitting element 1100 according to the present embodiment. FIG. 32 is a graph showing a relation between WPE when power consumption is 0.5 W and the In composition ratio of lower P-side optical guide layer 1111a in Configuration Example 2 of nitride semiconductor light-emitting element 1100 according to the present embodiment. FIG. 27 to FIG. 32 each show a relation in a corresponding one of cases in which thickness T1 of lower P-side optical guide layer 1111a is 9 nm, 20 nm, 40 nm, and 60 nm. In addition, the Al composition ratio of lower P-side optical guide layer 1111a is 4.0% in any of the cases.

It is clear from FIG. 28 to FIG. 32 that, with an increase in In composition ratio of lower P-side optical guide layer 1111a that is the AlGaInN layer, the operating voltage and the operating current decrease, and the optical confinement factor, effective refractive index difference ΔN, and the WPE increase. The In composition ratio of lower P-side optical guide layer 1111a may be set to a value higher than 0% based on FIG. 28 to FIG. 32.

It is clear from FIG. 28 to FIG. 30 and FIG. 32 that, with an increase in thickness T1 of lower P-side optical guide layer 1111a, the operating voltage and the operating current decrease, and the optical confinement factor and the WPE increase. Thickness T1 of lower P-side optical guide layer 1111a may be set to at least 9 nm based on FIG. 28 to FIG. 30 and FIG. 32. On the other hand, it is clear from FIG. 31 that when the In composition ratio of lower P-side optical guide layer 1111a is at least 1%, effective refractive index difference ΔN decreases with an increase in thickness T1, and increases with an increase in In composition ratio of lower P-side optical guide layer 1111a. Thickness T1 of lower P-side optical guide layer 1111a may be set to at most 60 nm based on FIG. 31 to achieve effective refractive index difference ΔN of at least approximately 10 × 10⁻³.

Referring to FIG. 27, although the optical waveguide loss hardly depends on the In composition ratio of lower P-side optical guide layer 1111a, the composition of lower P-side optical guide layer 1111a may be set to cause the band gap energy of lower P-side optical guide layer 1111a to be higher than the band gap energy of GaN, in order to reduce the occurrence of optical absorption loss in lower P-side optical guide layer 1111a. The Al composition ratio of lower P-side optical guide layer 1111a is at least 3% and at most 6%, and the In composition ratio of lower P-side optical guide layer 1111a may be greater than 0% and at most 2%. In order to increase the refractive index of lower P-side optical guide layer 1111a and improve electrical conductibility within such ranges of the Al composition ratio and the In composition ratio of lower P-side optical guide layer 1111a, the Al composition ratio and the In composition ratio may be set to cause the band bap energy of lower P-side optical guide layer 1111a to be smaller than or equal to the band gap energy of adjacent barrier layer 1107c.

The band gap energy of lower P-side optical guide layer 1111a may be smaller than or equal to the band gap energy of P-side optical guide layer 111. Since this makes it possible to cause the refractive index of lower P-side optical guide layer 1111a to be higher than or equal to the refractive index of P-side optical guide layer 111, it is possible to decrease the operating voltage and the operating current and increase the optical confinement factor, effective refractive index difference ΔN, and the WPE.

Lower P-side optical guide layer 1111a may be an undoped AlGaInN layer. For this reason, it is possible to reduce optical absorption caused by the above-described increase in impurity concentration.

By using the AlGaInN layer as lower P-side optical guide layer 1111a, it is possible to dispose, below and in the vicinity of ridge 21R, the AlGaInN layer that is a compressively strained layer relative to substrate 101. For this reason, it is possible to reduce shear stress in the lower end portion of ridge 21R caused by an AlGaN layer that is a tensibly strained layer relative to substrate 101. In addition, it is possible to reduce warping of a wafer that is a base material used when nitride semiconductor light-emitting element 1100 is manufactured, and reduce the occurrence of breaks in the wafer in a process after lower P-side optical guide layer 1111a is stacked.

The Al composition ratio of lower P-side optical guide layer 1111a may be equal to the Al composition ratio of adjacent barrier layer 1107c. In this case, when barrier layer 1107c and lower P-side optical guide layer 1111a are continuously formed, in a process of forming lower P-side optical guide layer 1111a, only an In composition ratio may be changed for a process of forming barrier layer 1107c. Accordingly, since it is possible to improve controllability of an atomic composition in the process of forming lower P-side optical guide layer 1111a, it is possible to make uniform an in-plane distribution (a distribution in a vertical plane in the stacking direction) of the composition of lower P-side optical guide layer 1111a. For this reason, for example, when a large number of nitride semiconductor light-emitting elements 1100 are formed on a wafer, it is possible to make the characteristics of each nitride semiconductor light-emitting element 1100 uniform. Additionally, the In composition ratio of lower P-side optical guide layer 1111a may change according to a position in the stacking direction. For example, an In composition ratio in a region of lower P-side optical guide layer 1111a closer to active layer 1107 may be higher than an In composition ratio in a region of lower P-side optical guide layer 1111a farther from active layer 1107. For this reason, since it is possible to reduce band gap energy in the region of lower P-side optical guide layer 1111a closer to active layer 1107, it is possible to improve conductibility of holes in the region. Accordingly, it is possible to further decrease the operating voltage of nitride semiconductor light-emitting element 1100.

Working examples of Configuration Example 2 of nitride semiconductor light-emitting element 1100 according to the present embodiment are described with reference to FIG. 33. FIG. 33 is a table showing configurations and characteristics in Working Examples 5 to 8 of nitride semiconductor light-emitting element 1100 according to the present embodiment. FIG. 33 also shows the configuration and characteristics of the nitride semiconductor light-emitting element according to Comparative Example 2.

As shown in FIG. 33, in Working Examples 5 to 8, the Al composition ratio and the In composition ratio of lower P-side optical guide layer 1111a are 4.0% and 1.3%, respectively. In Working Example 5, thickness T1 of lower P-side optical guide layer 1111a is 9.0 nm; in Working Example 6, thickness T1 of lower P-side optical guide layer 1111a is 20.0 nm; in Working Example 7, thickness T1 of lower P-side optical guide layer 1111a is 40.0 nm; and in Working Example 8, thickness T1 of lower P-side optical guide layer 1111a is 60.0 nm.

As shown in FIG. 33, in Working Examples 5 to 8, an operating voltage and an operating current decrease, and an optical confinement factor and WPE increase, compared to Comparative Example 2 in which lower P-side optical guide layer 1111a is not included. In addition, in Working Examples 5 to 8, it is possible to achieve effective refractive index difference ΔN of at least 10 × 10⁻³. As stated above, in Working Examples 5 to 8, since lower P-side optical guide layer 1111a is included, it is possible to decrease the operating voltage and the operating current and increase the optical confinement factor and the WPE while achieving effective refractive index difference ΔN of at least 10 × 10⁻³.

### [Variations etc.]

Although the nitride semiconductor light-emitting elements according to the present disclosure have been described above based on the respective embodiments, the present disclosure is not limited to the above-described embodiments.

For example, although the nitride semiconductor light-emitting element is exemplified as the semiconductor laser element in each of the above-described embodiments, the nitride semiconductor light-emitting element is not limited to the semiconductor laser element. For example, the nitride semiconductor light-emitting element may be a super-luminescent diode. In this case, a reflective index of the end face of the semiconductor structure included in the nitride semiconductor light-emitting element may be at most 0.1% relative to output light from the semiconductor structure. It is possible to achieve such a reflective index by, for example, providing an antireflective film including a dielectric multilayer film etc. in the end face. Alternatively, by forming a tilted stripe structure in which the ridge that becomes a waveguide is tilted at an angle of at least 5 degrees from the normal direction of a front end face to intersect with the front end face, it is possible to cause a ratio of components of guided light resulting from guided light reflected from the front end face being combined with the waveguide again to be a small value of at most 0.1%.

Moreover, although the impurity concentration of the P-type interlayer decreases with increasing distance from electron blocking layer 109 in Embodiments 1 to 5, an impurity concentration in at least a portion of the P-type interlayer may increase with increasing distance from electron blocking layer 109.

Furthermore, although the nitride semiconductor light-emitting elements according to respective Embodiments 7 to 9 include the P-type interlayers, the nitride semiconductor light-emitting elements need not include the P-type interlayers.

Moreover, although P-type cladding layer 112 is a layer that is uniform in Al composition ratio, the configuration of P-type cladding layer 112 is not limited to this example. For example, P-type cladding layer 112 may have a superlattice structure in which each of a plurality of AlGaN layers and each of a plurality of GaN layers are alternately stacked.

Furthermore, although the configuration in which P-side electrode 131 includes Ag is explained in above-described Embodiment 1, P-side electrode 131 may include Ag in the other embodiments. This allows the other embodiments to achieve the same advantageous effect achieved by P-side electrode 131 including Ag in Embodiment 1.

Moreover, forms obtained by various modifications to each of the above-described embodiments that can be conceived by a person skilled in the art or forms realized by arbitrarily combining the constituent elements and functions in each of the above-described embodiments as long as they are within the spirit of the present disclosure are included in the present disclosure.

For example, each of the configurations according to respective Embodiments 2 to 6 may be combined with each of the configurations according to respective Embodiments 7 to 9.

Furthermore, the P-type gradient region according to Embodiment 4 may be included in the P-type interlayers according to the other embodiments.

Moreover, the N-type gradient region according to Embodiment 9 may be included in the N-type interlayer according to Embodiment 7 or Embodiment 8.

### [Industrial Applicability]

The nitride semiconductor light-emitting element of the present disclosure is applicable to, for example, an exposure device and a light source for processing machine, as a high-power and highly efficient light source.

### [Reference Signs List]

10T element isolation trench
11R, 21R ridge
11Rs lateral face
11T, 21T trench
100, 300, 700, 1100 nitride semiconductor light-emitting element
100F, 100R end face
100S, 700S, 1100S semiconductor structure
101 substrate
102 foundation layer
103 buffer layer
104, 1104 N-type cladding layer
106, 706 N-side optical guide layer
107, 1107 active layer
107a, 107c, 1107c barrier layer
107b well layer
109 electron blocking layer
110, 210, 410, 510, 610, 1110 P-type interlayer
111 P-side optical guide layer
112 P-type cladding layer
113 contact layer
120 current blocking layer
131 P-side electrode
132 adhesion layer
133 pad electrode
140 N-side electrode
410a, 610a first P-type interlayer
410b, 610b second P-type interlayer
705, 805, 905, 1005 N-type interlayer
805a, 1005a first N-type interlayer
805b, 1005b second N-type interlayer
1110a lower P-side interlayer
1111a lower P-side optical guide layer

## Claims

1. A nitride semiconductor light-emitting element that emits light, the nitride semiconductor light-emitting element comprising:
a substrate:
an N-type cladding layer that is disposed above the substrate and includes Al;
an N-side optical guide layer that is disposed above the N-type cladding layer and includes Al;
an active layer that is disposed above the N-side optical guide layer and includes one or more well layers and a plurality of barrier layers that include Al;
an electron blocking layer that is disposed above the active layer and includes Al;
a P-type interlayer that is disposed above the electron blocking layer and includes Al;
a P-side optical guide layer that is disposed above the P-type interlayer and includes Al; and
a P-type cladding layer that is disposed above the P-side optical guide layer and includes Al,
wherein average band gap energy of the electron blocking layer is higher than average band gap energy of the P-type cladding layer,
average band gap energy of the P-type interlayer is higher than average band gap energy of the P-side optical guide layer, and is smaller than the average band gap energy of the electron blocking layer,
an average impurity concentration of the P-type interlayer is lower than an average impurity concentration of the electron blocking layer, and is higher than an average impurity concentration of the P-side optical guide layer, and
a peak wavelength of the light is less than 400 nm.

2. The nitride semiconductor light-emitting element according to claim 1,
wherein the average band gap energy of the P-type interlayer is smaller than the average band gap energy of the P-type cladding layer.

3. The nitride semiconductor light-emitting element according to claim 1 or claim 2,
wherein a thickness of the P-type interlayer is at least 10 nm.

4. The nitride semiconductor light-emitting element according to claim 3,
wherein the thickness of the P-type interlayer is at least 20 nm.

5. The nitride semiconductor light-emitting element according to any one of claim 1 to claim 4,
wherein the P-type interlayer is an AlGaN layer, and
an average Al composition ratio of the P-type interlayer is higher than 3%.

6. The nitride semiconductor light-emitting element according to any one of claim 1 to claim 5,
wherein an average Al composition ratio of each of the N-type cladding layer, the N-side optical guide layer, the P-type interlayer, the P-side optical guide layer, and the P-type cladding layer is less than 10%.

7. The nitride semiconductor light-emitting element according to any one of claim 1 to claim 6,
wherein the P-type interlayer includes:
a first P-type interlayer; and
a second P-type interlayer that is disposed above the first P-type interlayer and has average band gap energy that is smaller than average band gap energy of the first P-type interlayer.

8. The nitride semiconductor light-emitting element according to claim 7,
wherein the average band gap energy of the first P-type interlayer is higher than the average band gap energy of the P-type cladding layer, and
the average band gap energy of the P-type interlayer is smaller than the average band gap energy of the P-type cladding layer.

9. The nitride semiconductor light-emitting element according to any one of claim 1 to claim 6,
wherein the P-type interlayer includes:
a first P-type interlayer that has average band gap energy that is smaller than the average band gap energy of the P-type cladding layer; and
a second P-type interlayer that is disposed above the first P-type interlayer and has average band gap energy that is higher than the average band gap energy of the first P-type interlayer.

10. The nitride semiconductor light-emitting element according to any one of claim 1 to claim 9,
wherein the P-type interlayer includes a P-type gradient region that has an Al composition ratio that decreases with increasing distance from the electron blocking layer, and
the average band gap energy of the P-type interlayer is smaller than the average band gap energy of the P-type cladding layer.

11. The nitride semiconductor light-emitting element according to any one of claim 1 to claim 10, comprising:
a ridge that extends in a propagation direction of the light,
wherein at least a portion of the P-type interlayer is disposed in the ridge.

12. The nitride semiconductor light-emitting element according to any one of claim 1 to claim 10, comprising:
a ridge that extends in a propagation direction of the light,
wherein an inclination angle of a lateral face of the ridge relative to a principal face of the substrate is at least 60 degrees and less than 80 degrees.

13. The nitride semiconductor light-emitting element according to any one of claim 1 to claim 12, comprising:
a lower P-side optical guide layer that is disposed between the active layer and the electron blocking layer and includes Al,
wherein average band gap energy of the lower P-side optical guide layer is smaller than the average band gap energy of the P-type interlayer, and is smaller than average bang gap energy of an uppermost barrier layer among the plurality of barrier layers.

14. The nitride semiconductor light-emitting element according to claim 13, comprising:
a lower P-side interlayer that is disposed between the lower P-side optical guide layer and the electron blocking layer and includes Al,
wherein average band gap energy of the lower P-side interlayer is higher than the average band gap energy of the lower P-side optical guide layer, and is smaller than the average band gap energy of the electron blocking layer.

15. The nitride semiconductor light-emitting element according to claim 13 or claim 14,
wherein the lower P-side optical guide layer is an AlGaN layer.

16. The nitride semiconductor light-emitting element according to claim 13 or claim 14,
wherein the lower P-side optical guide layer is an AlGaInN layer.

17. A nitride semiconductor light-emitting element that emits light, the nitride semiconductor light-emitting element comprising:
a substrate;
an N-type cladding layer that is disposed above the substrate and includes Al;
an N-type interlayer that is disposed above the N-type cladding layer and includes Al;
an N-side optical guide layer that is disposed above the N-type interlayer and includes Al;
an active layer that is disposed above the N-side optical guide layer and includes one or more well layers and a plurality of barrier layers that include Al;
a P-side optical guide layer that is disposed above the active layer and includes Al; and
a P-type cladding layer that is disposed above the P-side optical guide layer and includes Al,
wherein average band gap energy of the N-type interlayer is higher than average band gap energy of the N-side optical guide layer, and is smaller than average band gap energy of the N-type cladding layer,
an average impurity concentration of the N-type interlayer is lower than or equal to an average impurity concentration of the N-type cladding layer, and is higher than an average impurity concentration of the N-side optical guide layer, and
a peak wavelength of the light is less than 400 nm.

18. The nitride semiconductor light-emitting element according to claim 17,
wherein a thickness of the N-type interlayer is at least 20 nm.

19. The nitride semiconductor light-emitting element according to claim 17 or claim 18,
wherein the N-type interlayer is an AlGaN layer, and
an average Al composition ratio of the N-type interlayer is higher than 3%.

20. The nitride semiconductor light-emitting element according to any one of claim 17 to claim 19,
wherein an average Al composition ratio of each of the N-type cladding layer, the N-side optical guide layer, the N-type interlayer, the P-side optical guide layer, and the P-type cladding layer is less than 10%.

21. The nitride semiconductor light-emitting element according to any one of claim 17 to claim 20,
wherein the N-type interlayer includes:
a first N-type interlayer; and
a second N-type interlayer that is disposed above the first N-type interlayer and has average band gap energy that is smaller than average band gap energy of the first N-type interlayer.

22. The nitride semiconductor light-emitting element according to any one of claim 17 to claim 21,
wherein the N-type interlayer includes an N-type gradient region that has an Al composition ratio that decreases with increasing distance from the N-side optical guide layer.
